# EUROPEAN PATENT APPLICATION

(11) **EP 2 706 461 A1**
(43) Date of publication of application: **12.03.2014**
(21) Application number: 13191796.5
(22) Date of filing: 08.02.2007
(51) Int. Cl.: G06F 12/10, G06F 13/16, G11C 7/10

(54) **Memory circuit system and method**

(30) Priority: 09.02.2006 US 772414 P; 31.07.2006 US 461437; 13.11.2006 US 865624 P; 05.02.2007 US 702960; 05.02.2007 US 702981
(62) Divisional of application: 11194883.2
(71) Applicant: Google Inc., Mountain View, CA 94043 (US)
(72) Inventor: Rajan, Suresh Natarajan, San Jose, CA 95132 (US); Smith, Michael John Sebastian, Palo Alto, CA 94306 (US); Schakel, Keith R., San Jose, CA 95135 (US); Wang, David T., San Jose, CA 95117 (US); Weber, Frederick Daniel, San Jose, CA 95125 (US)
(74) Representative: Schley, Jan Malte

(57) **Abstract**

A memory circuit system and method are provided. In one embodiment, an interface circuit is capable of communication with a plurality of memory circuits and a system. In use, the interface circuit is operable to interface the memory circuits and the system for reducing command scheduling constraints of the memory circuits. In another embodiment, an interface circuit is capable of communication with a plurality of memory circuits and a system. In use, the interface circuit is operable to translate an address associated with a command communicated between the system and the memory circuits. In yet another embodiment, at least one memory stack comprises a plurality of DRAM integrated circuits. Further, a buffer circuit, coupled to a host system, is utilized for interfacing the memory stack to the host system for transforming one or more physical parameters between the DRAM integrated circuits and the host system. In still yet another embodiment, at least one memory stack comprises a plurality of DRAM integrated circuits. Further, an interface circuit, coupled to a host system, is utilized for interfacing the memory stack to the host system so to operate the memory stack as a single DRAM integrated circuit.

## Description

### FIELD OF THE INVENTION

The present invention relates to memory, and more particularly to command scheduling constraints of memory circuits.

### BACKGROUND

Generally, as memory circuit interface speeds increase, the number of loads (or ranks) on a traditional multi-drop memory bus decreases in order to facilitate high speed operation of the bus. In addition, an exponential relationship between price and memory circuit density often exists, such that high density integrated circuits have a higher dollar per megabyte (Mb) ratio than mainstream density integrated circuits. Thus, an upper limit is generally placed on the amount of memory that can be economically utilized by a server. In addition, a larger printed circuit board area is generally required to provide larger memory capacity, thus limiting the memory capacity of smaller systems (e.g. servers).

Further, required data transfer speeds and bandwidth of memory systems have steadily increased, such that it has been necessary for more commands be scheduled, issued, and pipelined in a memory system in order to increase bandwidth. However, command scheduling constraints have customarily existed in memory systems which limit the command issue rates, and thus limit various attempts to further increase bandwidth, etc. There is thus, a need for addressing these and/or other issues associated with the prior art.

### SUMMARY

A memory circuit system and method are provided. In one embodiment, an interface circuit is capable of communication with a plurality of memory circuits and a system. In use, the interface circuit is operable to interface the memory circuits and the system for reducing command scheduling constraints of the memory circuits.

In another embodiment, an interface circuit is capable of communication with a plurality of memory circuits and a system. In use, the interface circuit is operable to translate an address associated with a command communicated between the system and the memory circuits.

In yet another embodiment, at least one memory stack comprises a plurality of DRAM integrated circuits. Further, a buffer circuit, coupled to a host system, is utilized for interfacing the memory stack to the host system for transforming one or more physical parameters between the DRAM integrated circuits and the host system.

In still yet another embodiment, at least one memory stack comprises a plurality of DRAM integrated circuits. Further, an interface circuit, coupled to a host system, is utilized for interfacing the memory stack to the host system so to operate the memory stack as a single DRAM integrated circuit.

### BRIEF DESCRIPTION OF THE DRAWINGS

Figure **1** illustrates a sub-system for interfacing memory circuits, in accordance with one embodiment.
Figure **2** illustrates a method for reducing command scheduling constraints of memory circuits, in accordance with another embodiment.
Figure **3** illustrates a method for translating an address associated with a command communicated between a system and memory circuits, in accordance with yet another embodiment.
Figure **4** illustrates a block diagram including logical components of a computer platform, in accordance with another embodiment.
Figure **5** illustrates a timing diagram showing an infra-device command sequence, intra-device timing constraints, and resulting idle cycles that prevent full use of bandwidth utilization in a DIR3 SDRAM memory system, in accordance with yet another embodiment.
Figure **6** illustrates a timing diagram showing a inter-device command sequence, inter-device timing constraints, and resulting idle cycles that prevent full use of bandwidth utilization in a DI3R SDRAM, DDR2 SDRAM, or DDR3 SDRAM memory system, in accordance with still yet another embodiment.
Figure **7** illustrates a block diagram showing an array of DRAM devices connected to a memory controller, in accordance with another embodiment.
Figure **8** illustrates a block diagram showing an interface circuit disposed between an array of DRAM devices and a memory controller, in accordance with yet another embodiment.
Figure **9** illustrates a block diagram showing a DDR3 SDRAM interface circuit disposed between an array of DRAM devices and a memory controller, in accordance with another embodiment.
Figure **10** illustrates a block diagram showing a burst-merging interface circuit connected to multiple DRAM devices with multiple independent data buses, in accordance with still yet another embodiment.
Figure **11** illustrates a timing diagram showing continuous data transfer over multiple commands in a command sequence, in accordance with another embodiment.
Figure **12** illustrates a block diagram showing a protocol translation and interface circuit connected to multiple DRAM devices with multiple independent data buses, in accordance with yet another embodiment.
Figure **13** illustrates a timing diagram showing the effect when a memory controller issues a column-access command late, in accordance with another embodiment.
Figure **14** illustrates a timing diagram showing the effect when a memory controller issues a column-access command early, in accordance with still yet another embodiment.
Figures **15A-15C** illustrate a DTMM with a plurality of DRAM stacks, in accordance with another embodiment.
Figure **16A** illustrates a D1MM PCB with buffered DRAM stacks, in accordance with yet another, embodiment.
Figure **16B** illustrates a buffered DRAM stack that emulates a 4 Gbyte DRAM, in accordance with still yet another embodiment.
Figure **17A** illustrates an example of a DJMM that uses the buffer integrated circuit and DRAM stack, in accordance with another embodiment.
Figure **17B** illustrates a physical stack of DRAMs in accordance with one embodiment, in accordance with yet another embodiment.
Figures **18A** and **18B** illustrate a multi-rank buffer integrated circuit and DIMM, in accordance with still yet another embodiment.
Figures **19A** and **19B** illustrate a buffer that provides a number of ranks on a D1MM equal to the number of valid integrated circuit selects from a host system, in accordance with another embodiment.
Figure **19C** illustrates a mapping between logical partitions of memory and physical partitions of memory, in accordance with yet another embodiment.
Figure **20A** illustrates a configuration between a memory controller and DIMMs, in accordance with still yet another embodiment.
Figure **20B** illustrates the coupling of integrated circuit select lines to a buffer on a DIMM for configuring the number of ranks based on commands from the host system, in accordance with another embodiment.
Figure **21** illustrates a DIMM PCB with a connector or interposer with upgrade capability, in accordance with yet another embodiment.
Figure **22** illustrates an example of linear address mapping for use with a multi-rank buffer integrated circuit, in accordance with still yet another embodiment.
Figure **23** illustrates an example of linear address mapping with a single rank buffer integrated circuit, in accordance with another embodiment.
Figure **24** illustrates an example of "bit slice" address mapping with a multi-rank buffer integrated circuit, in accordance with yet another embodiment.
Figure **25** illustrates an example of "bit slice" address mapping with a single rank buffer integrated circuit; in accordance with still yet another embodiment.
Figures **26A** and **26B** illustrate examples of buffered stacks that contain DRAM and non-volatile memory integrated circuits, in accordance with another embodiment.
Figures **27A, 27B** and **27C** illustrate a buffered stack with power decoupling layers, in accordance with yet another embodiment.
Figure **28** illustrates a representative hardware environment, in accordance with one embodiment.

### DETAILED DESCRIPTION

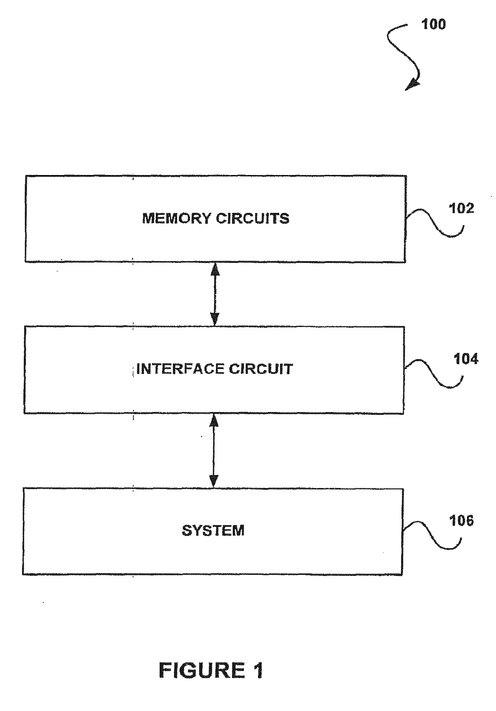

Figure **1** illustrates a sub-system **100** for interfacing memory circuits, in accordance with one embodiment. As shown, the sub-system **100** includes an interface circuit **104** coupled to memory circuits **102** and a system **106.** In the context of the present description, such memory circuits **102** may include any circuit capable of serving as memory.

For example, in various embodiments, at least one of the memory circuits **102** may include a monolithic memory circuit, a semiconductor die, a chip, a packaged memory circuit, or any other type of tangible memory circuit. In one embodiment, the memory circuits **102** may tape the form of dynamic random access memory (DRAM) circuits. Such DRAM may take any form including, but not limited to, synchronous DRAM (SDRAM), double data rate synchronous DRAM (DDR SDRAM, DDR2 SDRAM, DDR3 SDRAM, etc.), graphics double data rate DRAM (GDDR, GDDR2, GDDR3, etc.), quad data rate DRAM (QDR DRAM), RAMBUS XDR DRAM (XDR DRAM), fast page mode DRAM (FPM DRAM), video DRAM (VDRAM), extended data out DRAM (EDO DRAM), burst EDO RAM (BEDO DRAM), multibank DRAM (MDRAM), synchronous graphics RAM (SGRAM), and/or any other type of DRAM.

In another embodiment, at least one of the memory circuits **102** may include magnetic random access memory (MRAM), intelligent random access memory (RAM), distributed network architecture (DNA) memory, window random access memory (WRAM), flash memory (e.g.NAND, NOR, etc.), pseudostatic random access memory (PSRAM), wetware memory, memory based on semiconductor, atomic, molecular, optical, organic, biological, chemical, or nanoscale technology, and/or any other type of volatile or nonvolatile, random or non-random access, serial or parallel access memory circuit.

Strictly as an option, the memory circuits **102** may or may not be positioned on at least one dual in-line memory module (DIMM) (not shown). In various embodiments, the DIMM may include a registered DIMM (R-DIM), a small outline-DIMM (SO-DIN", a fully buffered DIMM (FB-DIMM), an unbuffered DIMM (UDIMM), single inline memory module (SINN), a MiniDIMM, a very low profile (VLP) R-DIMM, etc. In other embodiments, the memory circuits **102** may or may not be positioned on any type of material forming a substrate, card, module, sheet, fabric, board, carrier or any other type of solid or flexible entity, form, or object. Of course, in yet other embodiments, the memory circuits **102** may or may not be positioned in or on any desired entity, form, or object for packaging purposes. Still yet, the memory circuits **102** may or may not be organized into ranks. Such ranks may refer to any arrangement of such memory circuits **102** on any of the foregoing entities, forms, objects, etc.

Further, in the context of the present description, the system **106** may include any system capable of requesting and/or initiating a process that results in an access of the memory circuits **102.** As an option, the system **106** may accomplish this utilizing a memory controller (not shown), or any other desired mechanism. In one embodiment, such system **106** may include a system in the form of a desktop computer, a lap-top computer, a server, a storage system, a networking system, a workstation, a personal digital assistant (PDA), a mobile phone, a television, a computer peripheral (e.g. printer, etc.), a consumer electronics system, a communication system, and/or any other software and/or hardware, for that matter.

The interface circuit **104** may, in the context of the present description, refer to any circuit capable of interfacing (e.g. communicating, buffering, etc.) with the memory circuits **102** and the system **106.** For example, the interface circuit **104** may, in the context of different embodiments, include a circuit capable of directly (e.g. via wire, bus, connector, and/or any other direct communication medium, etc.) and/or indirectly (e.g. via wireless, optical, capacitive, electric field, magnetic field, electromagnetic field, and/or any other indirect communication medium, etc.) communicating with the memory circuits **102** and the system **106.** In additional different embodiments, the communication may use a direct connection:(e.g. point-to-point, single-drop bus, multi-drop bus, serial bus, parallel bus, link, and/or any other direct connection, etc.) or may use an indirect connection (e.g. through intermediate circuits, intermediate logic, an intermediate bus or busses, and/or any other indirect connection, etc.).

In additional optional embodiments, the interface circuit **104** may include one or more circuits, such as a buffer (e.g. buffer chip, etc.), a register (e.g. register chip, etc.), an advanced memory buffer (AMB) (e.g. AMB chip, etc.), a component positioned on at least one DIMM, a memory controller, etc. Moreover, the register may, in various embodiments, include a JEDEC Solid State Technology Association (known as JEDEC) standard register (a JEDEC register), a register with forwarding, storing, and/or buffering capabilities, etc. In various embodiments, the register chips, buffer chips, and/or any other interface circuit **104** may be intelligent, that is, include logic that is capable of one or more functions such as gathering and/or storing information; inferring, predicting, and/or storing state and/or status; performing logical decisions; and/or performing operations on input signals, etc. In still other embodiments, the interface circuit **104** may optionally be manufactured in monolithic form, packaged form, printed form, and/or any other manufactured form of circuit, for that matter. Furthermore, in another embodiment, the interface circuit **104** may; be positioned on a DIMM.

In still yet another embodiment, a plurality of the aforementioned interface circuit **104** may serve, in combination, to interface the memory circuits **102** and the system **106.** Thus, in various embodiments, one, two, three, four, or more interface circuits **104** may be utilized for such interfacing purposes. In addition, multiple interface circuits 104 may be relatively configured or connected in any desired manner. For example, the interface circuits **104** may be configured or connected in parallel, serially, or in various combinations thereof. The multiple interface circuits **104** may use direct connections to each other, indirect connections to each other, or even a combination thereof. Furthermore, any number of the interface circuits **104** may be allocated to any number of the memory circuits **102.** In various other embodiments, each of the plurality of interface circuits **104** may be the same or different. Even still, the interface circuits **104** may share the same or similar interface tasks and/or perform different interface tasks.

While the memory circuits **102,** interface circuit **104,** and system **106** are shown to be separate parts, it is contemplated that any of such parts (or portion(s) thereof) may be integrated in any desired manner. In various embodiments, such optional integration may involve simply packaging such parts together (e.g. stacking the parts to form a stack of DRAM circuits, a DRAM stack, a plurality of DRAM stacks, a hardware stack, where a stack may refer to any bundle, collection, or grouping of parts and/or circuits, etc.) and/or integrating them monolithically. Just by way of example, in one optional embodiment, at least one interface circuit **104** (or portion(s) thereof) may be packaged with at least one of the memory circuits **102.** In this way, the interface circuit **104** and the memory circuits **102** may take the form of a stack, in one embodiment.

For example, a DRAM stack may or may not include at least one interface circuit **104** (or portion(s) thereof). In other embodiments, different numbers of the interface circuit **104** (or portion(s) thereof) may be packaged together. Such different packaging arrangements, when employed, may optionally improve the utilization of a monolithic silicon implementation, for example.

The interface circuit **104** may be capable of various functionality, in the context of different embodiments. For example, in one optional embodiment, the interface circuit **104** may interface a plurality of signals that are connected between the memory circuits **102** and the system **106.** The signals may, for example, include address signals, data signals, control signals, enable signals, clock signals, reset signals, or any other signal used to operate or associated with the memory circuits **102,** system **106,** or interface circuit(s) **104,** etc. In some optional embodiments, the signals may be those that use a direct connection, use an indirect connection, use a dedicated connection, may be encoded across several connections, and/or may be otherwise encoded (e.g. time-multiplexed, etc.) across one or more connections.

In one aspect of the present embodiment, the interfaced signals may represent all of the signals that are connected between the memory circuits **102** and the system **106.** In other aspects, at least a portion of signals may use direct connections between the memory circuits **102** and the system **106.** Moreover, as an option, the number of interfaced signals (e.g. vs. a number of the signals that use direct connections, etc.) may vary such that the interfaced (signals may include at least a majority of the total number of signal connections between the memory circuits **102** and the system **106.**

In yet another embodiment, the interface circuit **104** may or may not be operable to interface a first number of memory circuits **102** and the, system **106** for simulating a second number of memory circuits to the system **106.** The first number of memory circuits **102** shall hereafter be referred to, where appropriate for clarification purposes, as the "physical" memory circuits **102** or memory circuits, but are not limited to be so. Just by way of example, the physical memory circuits **102** may include a single physical memory circuit. Further, the at least one simulated memory circuit seen by the system **106** shall hereafter bed referred to, where appropriate for clarification purposes, as the at least one "virtual" memory circuit.

In still additional aspects of the present embodiment, the second number of virtual memory circuits may be more than, equal to, or less than the first number of physical memory circuits **102.** Just by way of example, the second number of virtual memory circuits may include a single memory circuit. Of course, however, any number of memory circuits may be simulated.

In the context of the present description, the term simulated may refer to any simulating, emulating, disguising, transforming, modifying, changing, altering, shaping, converting, etc., which results in at least one aspect of the memory circuits **102** appearing different to the system **106.** 1 In different embodiments, such aspect may include, for example, a number, a signal a memory capacity, a timing, a latency, a design parameter, a logical interface, a control system, a property, a behavior (e.g. power behavior including, but not limited to a power consumption, current consumption, current waveform, power parameters, power metrics, any other aspect of power management or behavior, etc.), and/or any other aspect, for that matter.

In different embodiments, the simulation may be electrical in nature, logical in nature, protocol in nature, and/or performed in any other desired manner. For instance, in the context of electrical simulation, a number of pins, wires, signals, etc. may be simulated. In the context of logical simulation, a particular function or behavior may be simulated. In the context of protocol, a particular protocol (e.g. DDR3, etc.) maybe simulated. Further, in the context of protocol, the simulation may effect conversion between different protocols (e.g. DDR2 and DDR3) or may effect conversion between different versions of the same protocol (e.g. conversion of 4-4-4 DDR2 to 6-6-6 DDR2).

In one exemplary embodiment, memory storage cells of DRAM devices may be arranged into multiple banks, each bank having multiple rows, and each row having multiple columns. The memory storage capacity of the DRAM device may be equal to the number of banks times the number of rows per bank times the number of column per row times the number of storage bits per column. In commodity DRAM devices (e.g. SDRAM, DDR, DDR2, DDR3, DDR4, GDDR2, GDDR3 and GDDR4 SDRAM, etc.), the number of banks per device, the number of rows per bank, the number of columns per row, and the column sizes may be determined by a standards-forming committee, such as the Joint Electron Device Engineering Council (JEDEC).

For example, JEDEC standards require that a 1 gigabyte (Gb) DDR2 or DDR3 SDRAM device with a four-bit wide data bus have eight banks per device, 8192 rows per bank, 2048 columns per row, ;and four bits per column. Similarly, a 2 Gb device with a four-bit wide data bus must have eight banks per device, 16384 rows per bank, 2048 columns per row, and four bits per column. A 4 Gb device with a four-bit wide data bus must have eight banks per device, 32768 rows per bank, 2048 columns per row, and four bits per column. In the 1 Gb, 2Gb and 4Gb devices, the row size is constant, and the number of rows doubles with each doubling of device capacity. Thus, a 2 Gb or a 4 Gb device may be simulated, as described above, by using multiple I Gb and 2 Gb devices, and by directly translating row activation commands to row activation commands and column-access commands to column-access commands. In one embodiment, this emulation may be possible because the 1 Gb, 2 Gb, and 4 Gb devices have the same row size.

In one embodiment, an interface circuit is capable of communication with a plurality of memory circuits and a system. In use, the interface circuit is operable to interface the memory circuits and the system for reducing command scheduling constraints of the memory circuits.

In another embodiment, an interface circuit is capable of communication with a plurality of memory circuits and a system. In use, the interface circuit is operable to translate an address associated with a command communicated between the system and the memory circuits.

In yet another embodiment, at least one memory stack comprises a plurality of DRAM integrated circuits. Further, a buffer circuit, coupled to a host system, is utilized for interfacing the memory stack to the host system for transforming one or more physical parameters between the DRAM integrated circuits and the host system.

In still yet another embodiment, at least one memory stack comprises a plurality of DRAM integrated circuits. Further, an interface circuit, coupled to a host system, is utilized for interfacing the memory stack to the host system so to operate the memory stack as a single DRAM integrated circuit.

More illustrative information will now be set forth regarding various optional architectures and uses in which the foregoing system may or may not be implemented, per the desires of the user. It should be strongly noted that the following information is set forth for illustrative purposes and should not be construed as limiting in any manner. Any of the following features may be optionally incorporated with or without the exclusion of other features described.

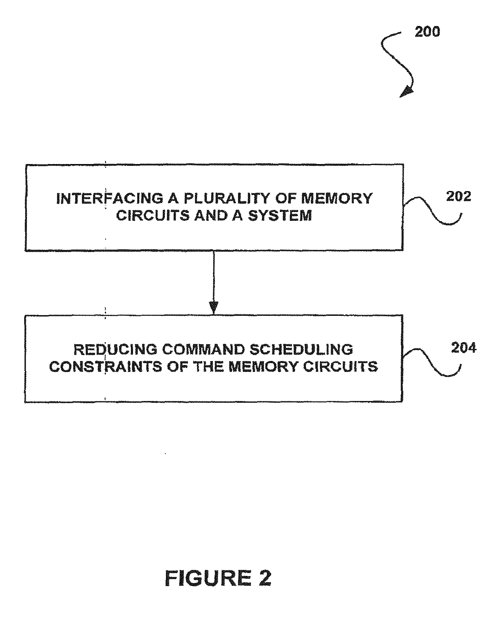

Figure **2** illustrates a method **200** for reducing command scheduling constraints of memory circuits, in accordance with another embodiment. As an option, the method **200** may be implemented in the system **100** of Figure **1**. Of course, the method **200** may be implemented in any desired environment. Further, the aforementioned definitions may equally apply to the description below.

As shown in operation **202,** a plurality of memory circuits and a system are interfaced. In one embodiment, the memory circuits and system may be interfaced utilizing an interface circuit. The interface circuit may include, for example, the interface circuit described above with, respect to Figure **1**. In addition, in one embodiment, the interfacing may include facilitating communication between the memory circuits and the system. Of course, however, the memory circuits and system may be interfaced in any desired matter.

Further, comma-rid scheduling constraints of the memory circuits are reduced, as shown in operation **204.** In the context of the present description, the command scheduling constraints may include any limitations associated with scheduling (and/or issuing) commands with respect to the memory circuits. Optionally, the command scheduling constraints may be defined by manufacturers in their memory device data sheets, by standards organizations such as the JEDEC, etc.

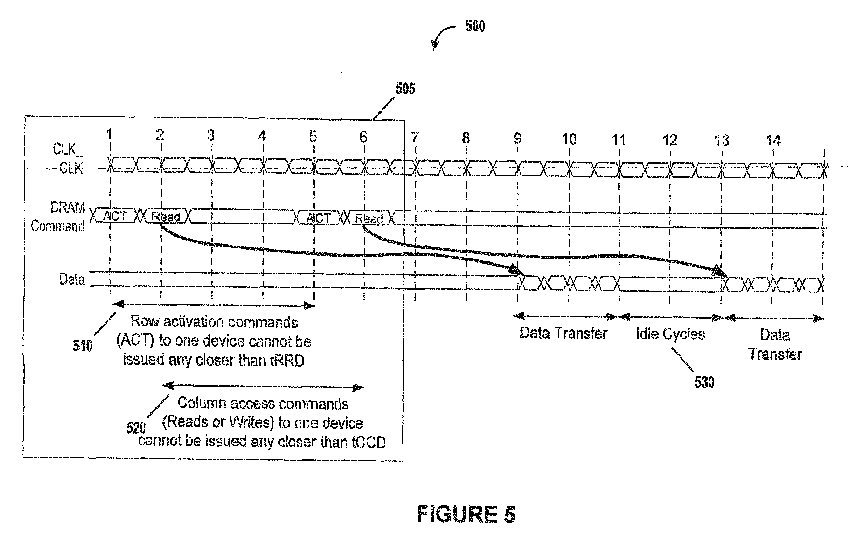

In one embodiment, the command scheduling constraints may include intra-device command scheduling constraints. Such intra-device command scheduling constraints may include scheduling constraints within a device. For example, the intra-device command scheduling constraints may include column-to-column delay time (tCCD), row-to-row activation delay time (tRRD), four-bank activation window time (tFAW), and write-to-read turn-around time (tWTR), etc. As an option, the intra-device command-scheduling constraints may be associated with parts of a device (e.g. column, row, bank, etc.) that share a resource within the device. One example of such intra-device command scheduling constraints will be described in more detail below with respect to Figure **5****.**

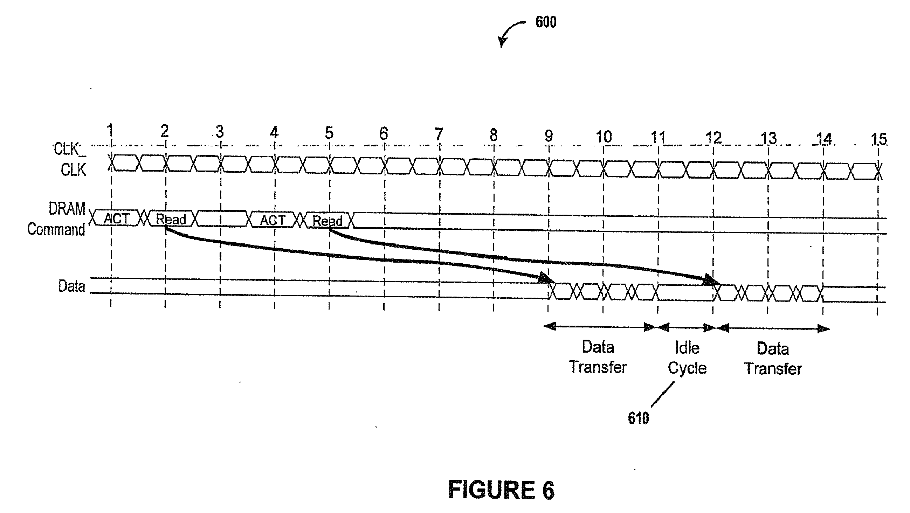

In one embodiment, the command scheduling constraints may include inter-device command scheduling constraints. Such inter-device scheduling constraints may include scheduling constraints between devices (e.g. memory devices). Just by way of example, the inter-device command scheduling constraints may include rank-to-rank data bus turnaround times, on-die-termination (ODT) control switching times, etc. Optionally, the inter-device command scheduling constraints may be associated with devices that share a resource (e.g. a data bus, etc.) which provides a connection therebetween (e.g. for communicating, etc.). One example of such inter-device command scheduling constraints will be described in more detail below with respect to Figure **6****.**

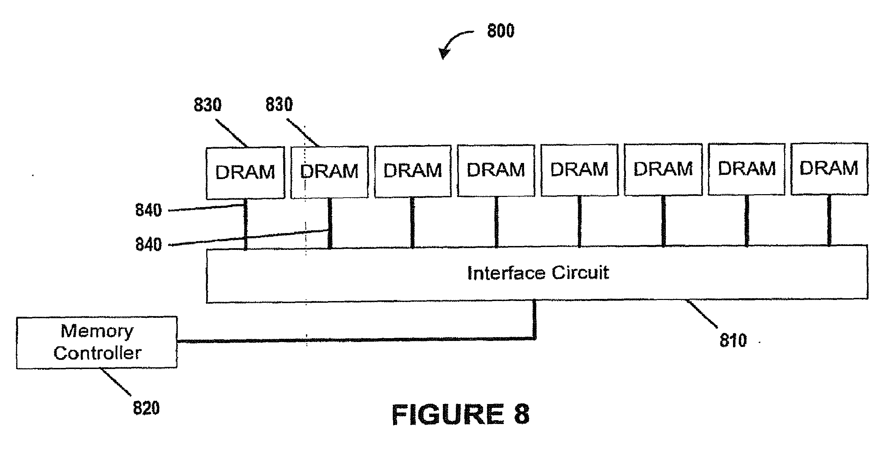

Further, reduction of the command scheduling restraints may include complete elimination and/or any decrease thereof. Still yet, the command scheduling constraints may be reduced by controlling the manner in which commands are issued to the memory circuits. Such commands may include, for example, row activation commands, column access commands, etc. Moreover, the commands may optionally be issued to the memory circuits utilizing separate busses associated therewith. One example of memory circuits associated with separate busses will be described in more detail below with respect to Figure **8****.**

In one embodiment, the command scheduling constraints may be reduced by issuing commands to the memory circuits based on simulation of a virtual memory circuit. For example, the plurality of memory circuits (i.e. physical memory circuits) and the system may be interfaced such that that the memory circuits appear to the system as a virtual memory circuit. Such simulated virtual memory circuit may optionally include the virtual memory circuit described above with respect to Figure **1**.

In addition, the virtual memory circuit may have less command scheduling constraints than the physical memory circuits. In one exemplary embodiment, the memory circuits may appear as a group of one or more memory circuits that are free from command scheduling constraints. Thus, as an option, the command scheduling constraints may be reduced by issuing commands directed to a single virtual memory circuit rather than a plurality of different physical memory circuits. In this way, idle data-bus cycles may optionally be eliminated and memory system bandwidth may be increased.

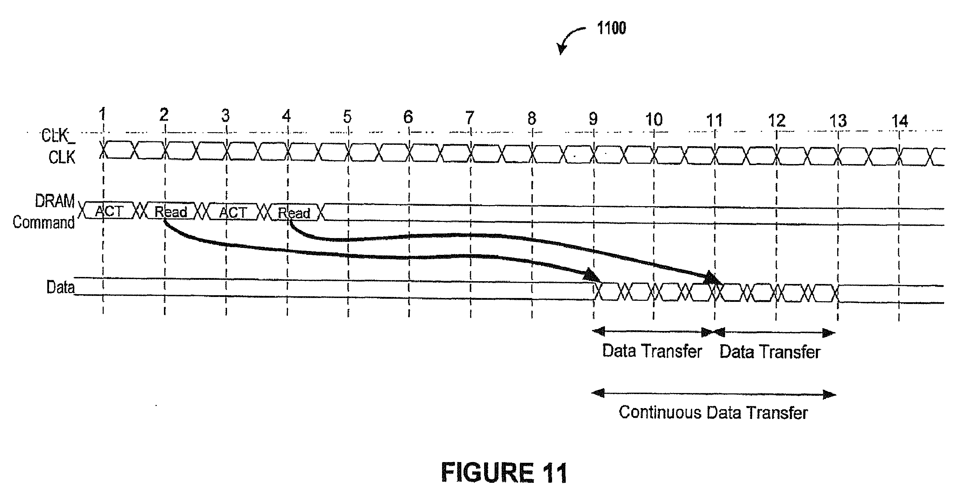

Of course, it should be noted that the command scheduling constraints may be reduced in any desired manner. Accordingly, in one embodiment, the interface circuit may be utilized to eliminate, at least in part, inter-device and/or intra-device command scheduling constraints of memory circuits (e.g. logical DRAM devices, etc.). Furthermore, reduction of the command scheduling constraints of the memory circuits may result in increased command issue rates. For example, a greater amount of commands may be issued to the memory circuits by reducing limitations associated with the command scheduling constraints. More information regarding increasing command issue rates by reducing command scheduling constraints will be described with respect to Figure **11****.**

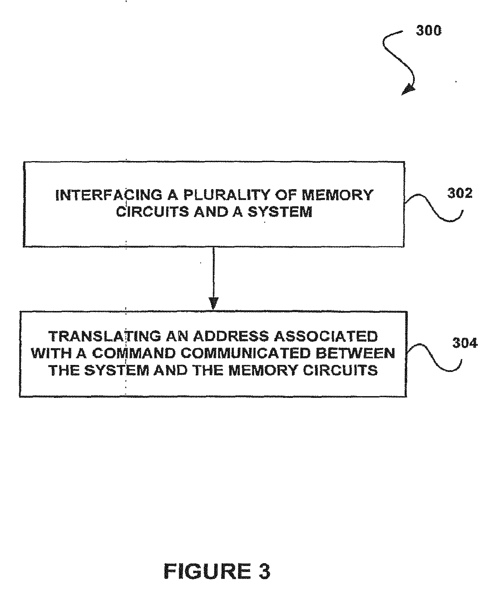

Figure **3** illustrates a method **300** for translating an address associated with a command communicated between a system and memory circuits, in accordance with yet another embodiment. As an option, the method **300** may be carried out in context of the architecture and environment of Figures **1** and/or **2.** Of course, the method **300** may be carried out in any desired environment. Further, the aforementioned definitions may equally apply to the description below.

As shown in operation **302,** a plurality of memory circuits and a system are interfaced. In one embodiment, the memory circuits and system may be interfaced utilizing an interface circuit, such as that described above with respect to Figure **1****,** for example. In one embodiment, the interfacing may include facilitating communication between the memory circuits and the system. Of course, however, the memory circuits and system may be interfaced in any desired manner.

Additionally, an address associated with a command communicated between the system and the memory circuits is translated, as shown in operation **304.** Such command may include, for example, a row-activation command, a column-access command, and/or any other command capable of being communicated between the system and the memory circuits. As an option, the translation may be transparent to the system. In this way, the system may issue a command to the memory circuits, and such command may be translated without knowledge and/or input by the system.

Further, the address may be translated in any desired manner. Such translation may include any converting, changing, transforming, etc. In one embodiment, the translation of the address may include shifting the address. In another embodiment, the address may be translated by mapping the address. Optionally, as described above with respect to Figures **1** and/or **2,** the memory circuits may include physical memory circuits and the interface circuit may simulate a virtual memory circuit. To this end, the virtual memory circuit may optionally have a different (e.g. greater, etc.) number of row addresses associated therewith than the physical memory circuits.

Thus, in another embodiment, the translation may be performed as a function of the difference in the number of row addresses. In yet another embodiment, the translation may translate the address to reflect the number of row addresses of the virtual memory circuit. In still yet another embodiment, the translation may optionally translate the address as a function of a column address and a row address.

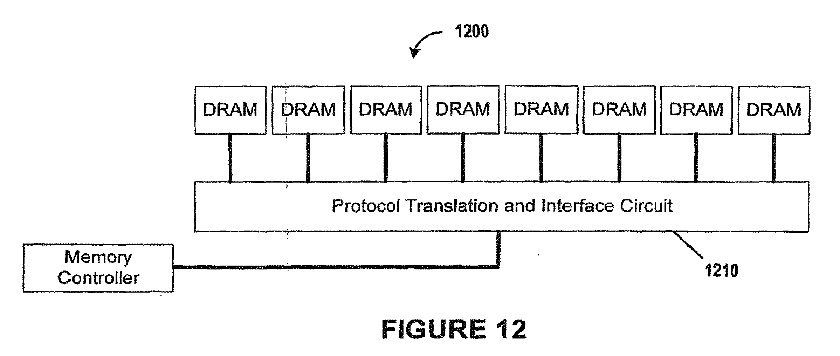

Thus, in one exemplary embodiment where the command includes a row-access command, the translation may be performed as a function of an expected arrival time of a column-access command. In another exemplary embodiment, where the command includes a row-access command, the translation may ensure that a column-access command addresses an open bank. Optionally, the interface circuit may be operable to delay the command communicated between the system and the memory circuits. To this end, the translation may result in sub-row activation of the memory circuits (e.g. logical DRAM device, etc.). Various examples of address translation will be described in more detail below with respect to Figures **8** and **12**.

Accordingly, in one embodiment, address mapping may use shifting of an address from one command to another to allow the use memory circuits with smaller rows to emulate a larger memory circuit with larger rows. Thus, sub-row activation may be provided. Such sub-row activation may also reduce power consumption and may further improve performance, in various embodiments.

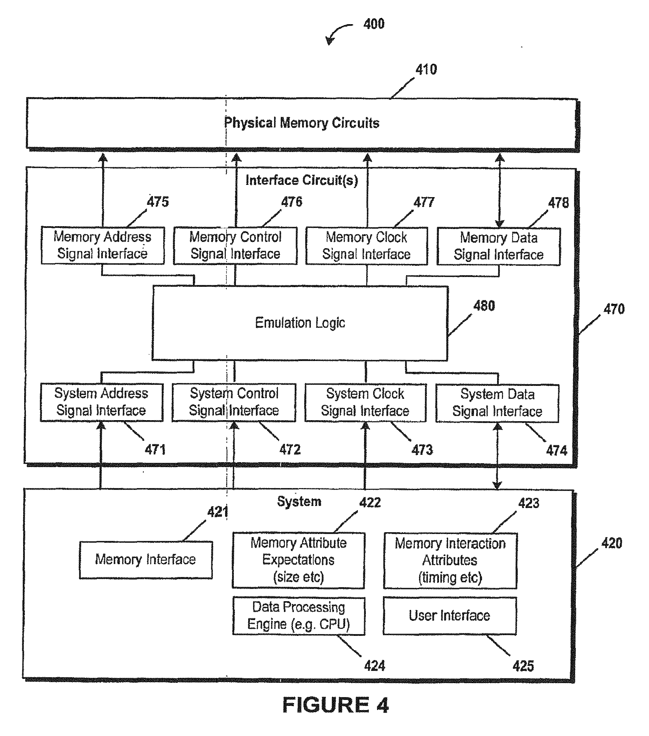

Figure **4** illustrates a block diagram including logical components of a computer platform **400,** in accordance with another embodiment. As an option, the computer platform **400** may be implemented in context of the architecture and environment of Figures **1-3****.** Of course, the computer platform **400** may be implemented in any desired environment. Further, the aforementioned definitions may equally apply to the description below.

As shown, the computer platform **400** includes a system **420.** The system **420** includes a memory interface **421,** logic for retrieval and storage of external memory attribute expectations **422,** memory interaction attributes **423,** a data processing engine **424,** and various mechanisms)to facilitate a user interface **425**. The computer platform **400** may be comprised of wholly separate components, namely a system **420** (e.g. a motherboard, etc.), and memory circuits 410 (e.g. physical memory circuits, etc.). In addition, the computer platform **400** may optionally include memory circuits **410** connected directly to the system **420** by way of one or more sockets.

In one embodiment, the memory circuits **410** may be designed to the specifics of various standards, including for example, a standard defining the memory circuits **410** to be JEDEC-compliant semiconductor memory (e.g. DRAM, SDRAM, DDR2, DDR3, etc.). The specifics of such standards may address physical interconnection and logical capabilities of the memory circuits **410**.

In another embodiment, the system **420** may include a system BIOS program (not shown) capable of interrogating the physical memory circuits **410** (e-g. DIMMs) to retrieve and store memory attributes **422, 423**. Further, various types of external memory circuits **410,** including for example JEDEC-compliant DIMMs, may include an EEPROM device known as a serial presence detect (SPD) where the DIMM's memory attributes are stored. The interaction of the BIOS with the SPD and the interaction of the BIOS with the physical memory circuits' **410** physical attributes may allow the system's **420** memory attribute expectations **422** and memory interaction attributes **423** may become known to the system **420.**

In various embodiments, the computer platform **400** may include one or more interface circuits **470** electrically disposed between the system **420** and the physical memory circuits **410**. The interface circuit **470** may include several system-facing interfaces (e.g. a system address signal interface **471,** a system control signal interface **472,** a system clock signal interface **473,** a system data signal interface **474,** etc.). Similarly, the interface circuit **470** may include several memory-facing interfaces (e.g. a memory address signal interface **475,** a memory control signal interface **476,** a memory clock signal interface **477,** a memory data signal interface **478,** etc.).

Still yet, the interface circuit **470** may include emulation logic **480.** The emulation logic **480** may be operable to receive and optionally store electrical signals (e.g. logic levels, commands, signals, protocol sequences, communications, etc.) from or through the system-facing interfaces, and may further be operable to process such electrical signals. The emulation logic **480** may respond to signals from system-facing interfaces by responding back to the system **420** and presenting signals to the system **420,** and may also process the signals with other information previously stored. As another option, the emulation logic **480** may present signals to the physical memory circuits **410**. Of course, however, the emulation logic **480** may perform any of the aforementioned functions in any order.

Moreover, the emulation logic **480** may be operable to adopt a personality, where such personality is capable of defining the physical memory circuit attributes. In various embodiments, the personality may be effected via any combination of bonding options, strapping, programmable strapping, the wiring between the interface circuit **470** and the physical memory circuits **410**. Further, the personality may be effected via actual physical attributes (e.g. value of mode register, value of extended mode register) of the physical memory circuits **410** connected to the interface circuit **470** as determined when the interface circuit **470** and physical memory circuits **410** are powered up.

Figure **5** illustrates a timing diagram **500** showing an infra-device command sequence, intra-device timing constraints, and resulting idle cycles that prevent full use of bandwidth utilization in a DDR3 SDRAM memory system, in accordance with yet another embodiment. As an option, the timing diagram **500** may be associated with the architecture and environment of Figures **1-4****.** Of course, the timing diagram **500** may be associated with any desired environment. Further, the aforementioned definitions may equally apply to the description below.

As shown, the timing diagram **500** illustrates command cycles, timing constraints and idle cycles of memory. For example, in an embodiment involving DDR3 SDRAM memory systems, any two row-access commands directed to a single DRAM device may not necessarily be scheduled closer than tRRD. As another example, at most four row-access commands may be scheduled within tFAW to a single DRAM device. Moreover, consecutive column-read access commands and consecutive column-write access commands may not necessarily be scheduled to a given DRAM device any closer than tCCD, where tCCD equals four cycles (eight half-cycles of data) in DDR3 DRAM devices.

In the context of the present embodiment, row-access and/or row-activation commands are shown as ACT. In addition, column-access commands are shown as READ or WRITE. Thus, for example, in memory systems that require a data access in a data burst of four half-cycles, as shown in Figure **2****,** the tCCD constraint may prevent column accesses from being scheduled consecutively. Further, the constraints **510, 520** imposed on the DRAM commands sent to a given DRAM device may restrict the command rate, resulting in idle cycles or bubbles **530** on the data bus, therefore reducing the bandwidth.

In another optional embodiment involving DDR3 SDRAM memory systems, consecutive column-access commands sent to different DRAM devices on the same data bus may not necessarily be scheduled any closer than a period that is the sum of the data burst duration plus additional idle cycles due to rank-to-rank data bus turn-around times. In the case of column-read access commands, two DRAM devices on the same data bus may represent two bus masters. Optionally, at least one idle cycle on the bus may be needed for one bus master to complete delivery of data to the memory controller and release control of the shared data bus, such that another bus master may gain control of the data bus and begin to send data.

Figure **6** illustrates a timing diagram **600** showing inter-device command sequence, inter-device timing: constraints, and resulting idle cycles that prevent full use of bandwidth utilization in a DDR SDRAM, DDR2 SDRAM, or DDR3 SDRAM memory system, in accordance with still yet another embodiment. As an option, the timing diagram **600** may be associated with the architecture and environment of Figures **1-4****.** Of course, the timing diagram **600** may be associated with any desired environment. Further, the aforementioned definitions may equally apply to the description below.

As shown, the timing diagram **600** illustrates commands issued to different devices that are free from constraints such as tRRD and tCCD which would otherwise be imposed on commands issue to the same device. However, as also shown, the data bus hand-off from one device to, another device requires at least one idle data-bus cycle **610** on the data bus. Thus, the timing diagram **600** illustrates a limitation preventing full use of bandwidth utilization in a DDR3 SDRAM memory system. As a consequence of the command-scheduling constraints, there may be no available command sequence that allows full bandwidth utilization in a DDR3 SDRAM memory system, which also uses bursts shorter than tCCD.

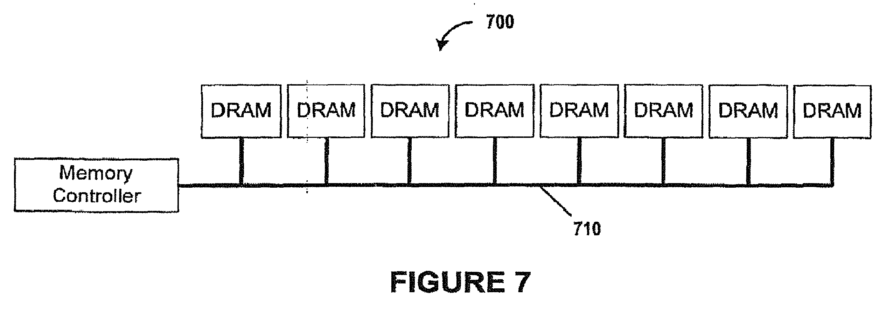

Figure **7** illustrates a block diagram **700** showing an array of DRAM devices connected to a memory controller, in accordance with another embodiment. As an option, the block diagram **700** may be associated with the architecture and environment of Figures **1-6****.** Of course, the block diagram **700** may be associated with any desired environment. Further, the aforementioned definitions may equally apply to the description below.

As shown, eight DRAM devices are connected directly to a memory controller through a shared data bus **710.** Accordingly, commands from the memory controller that are directed to the DRAM devices may be issued with respect to command scheduling constraints (e.g. tRRD, tCCD, tFAW, tWTR, etc.). Thus, the issuance of commands may be delayed based on such command scheduling constraints.

Figure **8** illustrates a block diagram **800** showing an interface circuit disposed between an array of DRAM devices and a memory controller, in accordance with yet another embodiment. As an option, the block diagram **800** may be associated with the architecture and environment of Figures **1-6****.** Of course, the block diagram **800** may be associated with any desired ;environment. Further, the aforementioned definitions may equally apply to the description below.

As shown, an interface circuit **810** provides a DRAM interface to the memory controller **820,** and directs commands to independent DRAM devices **830.** The memory devices **830** may each be associated with a different data bus **540,** thus preventing inter-device constraints. In addition, individual and independent memory devices **830** may be used to emulate part of a virtual memory device (e.g. column, row, bank, etc.). Accordingly, intra-device constraints may also be prevented. To this end, the memory devices **830** connected to the, interface circuit **510** may appear to the memory controller **820** as a group of one or more memory devices **530** that are free from command-scheduling constraints.

In one exemplary embodiment, N physical DRAM devices may be used to emulate M logical DRAM devices through the use of the interface circuit. The interface circuit may accept a command stream from a memory controller directed toward the M logical devices. The interface; circuit may also translate the commands to the N physical devices that are connected to the interface circuit via P independent data paths. The command translation may include, for example, routing the correct command directed to one of the M logical devices to the correct device (i.e. one of the N physical devices). Collectively, the P data paths connected to the N physical devices may optionally allow the interface circuit to guarantee that commands may be executed in parallel and independently, thus preventing command-scheduling constraints associated with the N physical devices. In this way the interface circuit may eliminate idle data-bus cycles or bubbles that would otherwise be present due to inter-device and intra-device command-scheduling constraints.

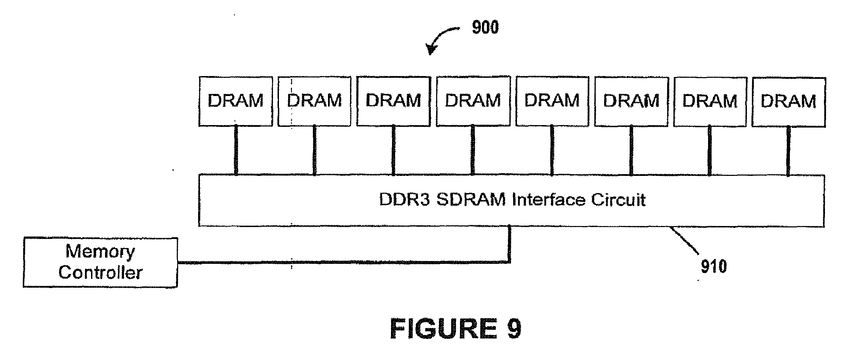

Figure **9** illustrates a block diagram **900** showing a DDR3 SDRAM interface circuit disposed between an array of DRAM devices and a memory controller, in accordance with another embodiment. As an option, the block diagram **900** may be associated with the architecture and environment of Figures **1-8****.** Of course, the block diagram **900** may be associated with any desired environment. Further, the aforementioned definitions may equally apply to the description below.

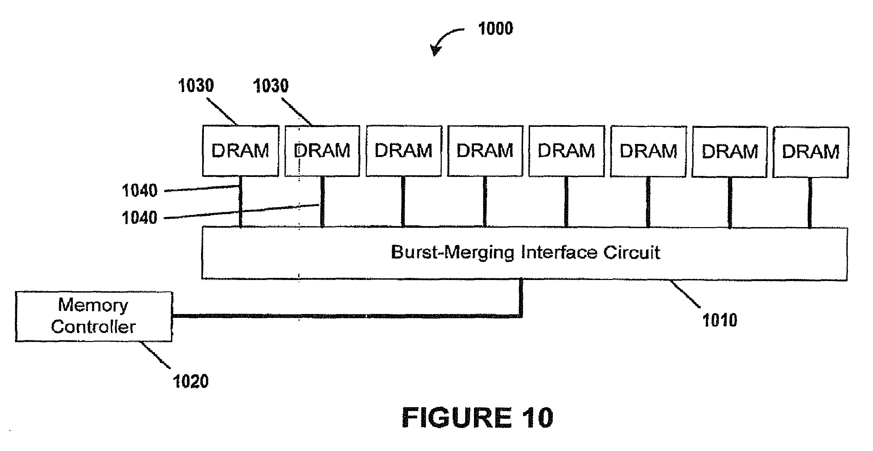

As shown, a DDR3 SDRAM interface circuit **910** eliminates idle data-bus cycles due to inter-device and intra-device scheduling constraints. In the context of the present embodiment, the DDR3 SDRAM interface circuit **910** may include a command translation circuit of an interface circuit that connects multiple DDR3 SDRAM devices with multiple independent data buses. For example, the DDR3 SDRAM interface circuit **910** may include command-and-control and address components capable of intercepting signals between the physical memory circuits and the system. Moreover, the command-and-control and address components may allow for burst merging, as described below with respect to Figure **10****.**

Figure **10** illustrates a block diagram **1000** showing a burst-merging interface circuit connected to multiple DRAM devices with multiple independent data buses, in accordance with still yet another embodiment. As an option, the block diagram **1000** may be associated with the architecture and environment of Figures **1-9****.** Of course, the block diagram **1000** may be associated with any desired environment. Further, the aforementioned definitions may equally apply to the description below.

The burst-merging interface circuit **1010** may include a data component of an interface circuit that connects multiple DRAM devices **1030** with multiple independent data buses **1040.** In addition, the burst-merging interface circuit **1010** may merge multiple burst commands received within a time period. As shown, eight DRAM devices **1030** may be connected via eight independent data paths to the burst-merging interface circuit **1010.** Further, the burst-merging interface circuit **1010** may utilize a single data path to the memory controller **820.** It should be noted that while eight DRAM devices **1030** are shown herein, in other embodiments, 16, 24, 32, etc. devices may be connected to the eight independent data paths. In yet another embodiment, there may be two, four, eight, 16 or more independent data paths associated with the DRAM devices **1030.**

The burst-merging interface circuit **1010** may provide a single electrical interface to the memory controller **1020,** therefore eliminating inter-device constraints (e.g. rank-to-rank turnaround time, etc.). In one embodiment, the memory controller **1020** may be aware that it is indirectly controlling the DRAM devices **1030** through the burst-merging interface circuit **1010,** and that no bus turnaround time is needed. In another embodiment, the burst-merging interface circuit **1010** may use the DRAM devices **1030** to emulate M logical devices. The burst-merging interface circuit **1010** may further translate row-activation commands and column-access commands to one of the DRAM devices 1030 in order to ensure that inter-device constraints (e.g. tRRD, tCCD, tFAW and tWTR etc.) are met by each individual DRAM device **1030,** while allowing the burst-merging interface circuit **1010** to present itself as M logical devices that are free from inter-device constraint.

Figure **11** illustrates a timing diagram **1100** showing continuous data transfer over multiple commands in a command sequence, in accordance with another embodiment. As an option, the timing diagram **1100** may be associated with the architecture and environment of Figures **1-10****.** Of course, the timing diagram **1100** may be associated with any desired environment. Further, the aforementioned definitions may equally apply to the description below.

As shown, inter-device and intra-device constraints are eliminated, such that the burst-merging interface circuit may permit continuous burst data transfers on the data bus, therefore increasing data bandwidth. For example, an interface circuit associated with the burst-merging interface circuit may present an industry-standard DRAM interface to a memory controller as one or more DRAM devices that are free of command-scheduling constraints. Further, the interface circuits may allow the DRAM devices to be emulated as being free from command-scheduling constraints without necessarily changing the electrical interface or the command set of the DRAM memory system. It should be noted that the interface circuits described herein may include any type of memory system (e.g. DDR2, DDR3, etc.).

Figure **12** illustrates a block diagram **1200** showing a protocol translation and interface circuit connected to multiple DRAM devices with multiple independent data buses, in accordance with yet another embodiment. As an option, the block diagram **1200** may be associated with the architecture and environment of Figures **1-11****.** Of course, the block diagram **1200** may be associated with any desired environment. Further, the aforementioned definitions may equally apply to the description below.

As shown, a protocol translation and interface circuit **1210** may perform protocol translation and/or manipulation functions, and may also act as an interface circuit. For example, the protocol translation and interface circuit **1210** maybe included within an interface circuit connecting a memory controller with multiple memory devices.

In one embodiment, the protocol translation and interface circuit **1210** may delay row-activation commands and/or column-access commands. The protocol translation and interface circuit **1210** may also transparently perform different kinds of address mapping schemes that depend on the expected arrival time of the column-access command. In one scheme, the column-access command may be sent by the memory controller at the normal time (i.e. late arrival, as compared to a scheme where the column-access command is early).

In a second scheme, the column-access command may be sent by the memory controller before the row-access command is required (i.e. early arrival) at the DRAM device interface. In DDR2 arid DDR3 SDRAM memory systems, the early arriving column-access command may be referred to as the Posted-CAS command. Thus, part of a row may be activated as needed, therefore providing sub-row activation. In addition, lower power may also be provided.

It should be noted that the embodiments of the above-described schemes may not necessarily require additional pins or new commands to be sent by the memory controller to the protocol translation and interface circuit. In this way, a high bandwidth DRAM device may be provided.

As shown, the protocol translation and interface circuit **1210** may include eight DRAM devices to be connected thereto via eight independent data paths to. For example, the protocol translation and interface circuit **1210** may emulate a single 8 Gb DRAM device with eight 1 Gb DRAM devices. The memory controller may therefore expect to see eight banks, 32768 rows per bank, 4096 columns per row, and four bits per column. When the memory controller issues a row-activation command, it may expect that 4096 columns are ready for a column-access command that follows, whereas the 1 Gb devices may only have 2048 columns per row. Similarly, the same issue of differing row sizes may arise when 2 Gb devices are used to emulate a 16 Gb DRAM device or 4 Gb devices are used to emulate a 32 Gb device, etc.

To accommodate for the difference between the row sizes of the 1 Gb and 8 Gb DRAM devices, 2 Gb and 16 Gb DRAM devices, 4 Gb and 32 Gb DRAM devices, etc., the protocol translation and interface circuit **1210** may calculate and issue the appropriate number of row-activation commands to prepare for a subsequent column-access command that may access any portion of the larger row. The protocol translation and interface circuit **1210** may be configured with different behaviors, depending on the specific condition.

In one exemplary embodiment, the memory controller may not issue early column-access commands. The protocol translation and interface circuit **1210** may activate multiple, smaller rows to match the size of the larger row in the higher capacity logical DRAM device.

Furthermore, the protocol translation and interface circuit **1210** may present a single data path to the memory controller, as shown. Thus, the protocol translation and interface circuit **1210** may present itself as a single DRAM device with a single electrical interface to the memory controller. For example, if eight 1 Gb DRAM devices are used by the protocol translation and interface circuit **1210** to emulate a single, standard 8 Gb DRAM device, the memory controller may expect that the logical 8 Gb DRAM device will take over 300 ns to perform a refresh command. The protocol translation and interface circuit **1210** may also intelligently schedule the refresh commands. Thus, for example, the protocol translation and interface circuit **1210** may separately schedule refresh commands to the 1 Gb DRAM devices, with each refresh command taking 100 ns.

To this end, where multiple physical DRAM devices are used by the protocol translation and interface circuit **1210** to emulate a single larger DRAM device, the memory controller may expect that the logical device may take a relatively long period to perform a refresh command. The protocol translation and interface circuit **1210** may separately schedule refresh commands to each of the physical DRAM devices. Thus, the refresh of the larger logical DRAM device may take a relatively smaller period of time as compared with a refresh of a physical DRAM device of the same size. DDR3 memory systems may potentially require calibration sequences to ensure that the high speed data I/O circuits are periodically calibrated against thermal-variances induced timing drifts. The staggered refresh commands may also optionally guarantee I/O quiet time required to separately calibrate each of the independent physical DRAM devices.

Thus, in one embodiment, a protocol translation and interface circuit **1210** may allow for the staggering of refresh times of logical DRAM devices. DDR3 devices may optionally require different levels of zero quotient (ZQ) calibration sequences, and the calibration sequences mays require guaranteed system quiet time, but may be power intensive, and may require that other I/O's in the system are not also switching at the same time. Thus, refresh commands in a higher capacity logical DRAM device may be emulated by staggering refresh commands to different lower capacity physical DRAM devices. The staggering of the refresh commands may optionally provide a guaranteed I/O quiet time that may be required to separately calibrate each of the independent physical DRAM devices.

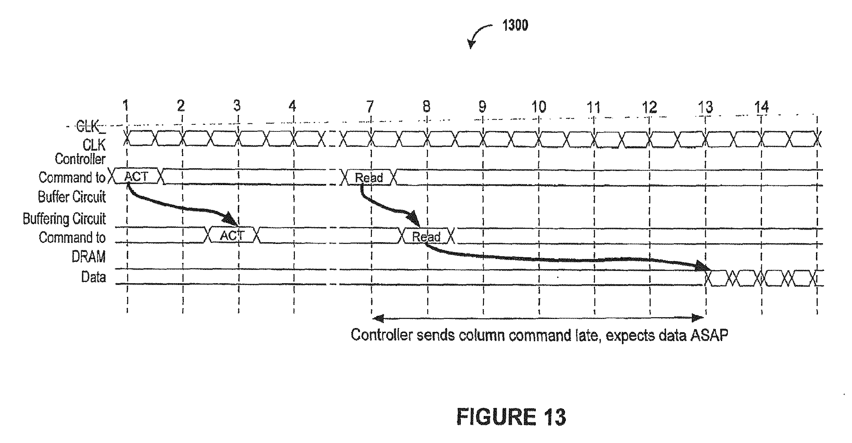

Figure **13** illustrates a timing diagram **1300** showing the effect when a memory controller issues a column-access command late, in accordance with another embodiment. As an option, the timing diagram **1300** may be associated with the architecture and environment of Figures **1-12****.** Of course, the timing diagram **1300** may be associated with any desired environment. Further, the aforementioned definitions may equally apply to the description below.

As shown, in a memory system where the memory controller issues the column-access command without enough latency to cover both the DRAM device's row-access latency and column-access latency, the interface circuit may send multiple row-access commands to multiple DRAM devices to guarantee that the subsequent column access will hit an open bank. In one exemplary embodiment, the physical device may have a 1 kilobyte (kb) row size and the logical device may have a 2 kb row size. In this case, the interface circuit may activate two 1 kb rows in two different physical devices (since two rows may not be activated in the same device within a span of tRRD). In another exemplary embodiment, the physical device may have a 1 kb row size and the logical device may have a 4 kb row size. In this case, four 1 kb rows may be opened to prepare for the arrival of a column-access command that may be targeted to any part of the 4 kb row.

In one embodiment, the memory controller may issue column-access commands early. The interface circuit may do this in any desired manner, including for example, using the additive latency property of DDR2 and DDR3 devices. The interface circuit may also activate one specific row in one specific DRAM device. This may allow sub-row activation for the higher capacity logical DRAM device.

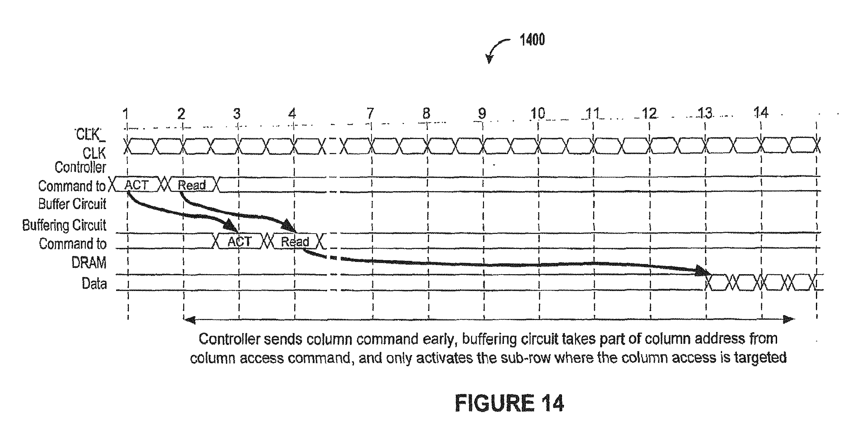

Figure **14** illustrates a timing diagram **1400** showing the effect when a memory controller issues a column-access command early, in accordance with still yet another embodiment. As an option, the timing diagram **1400** may be associated with the architecture and environment of Figures **1-13****.** Of course, the timing diagram **1400** may be associated with any desired environment. Further, the aforementioned definitions may equally apply to the description below.

In the context of, the present embodiment, a memory controller may issue a column-access command early, i.e. before the row-activation command is to be issued to a DRAM device. Accordingly, an interface circuit may take a portion of the column address, combine it with the row address and form a sub-row address. To this end, the interface circuit may activate the row that is targeted by the column-access command. Just by way of example, if the physical device has a 1 kb row size and the logical device has a 2 kb row size, the early column-access command may allow the interface circuit to activate a single 1 kb row. The interface circuit can thus implement sub-row activation for a logical device with a larger row size than the physical devices without necessarily the use of additional pins or special commands.

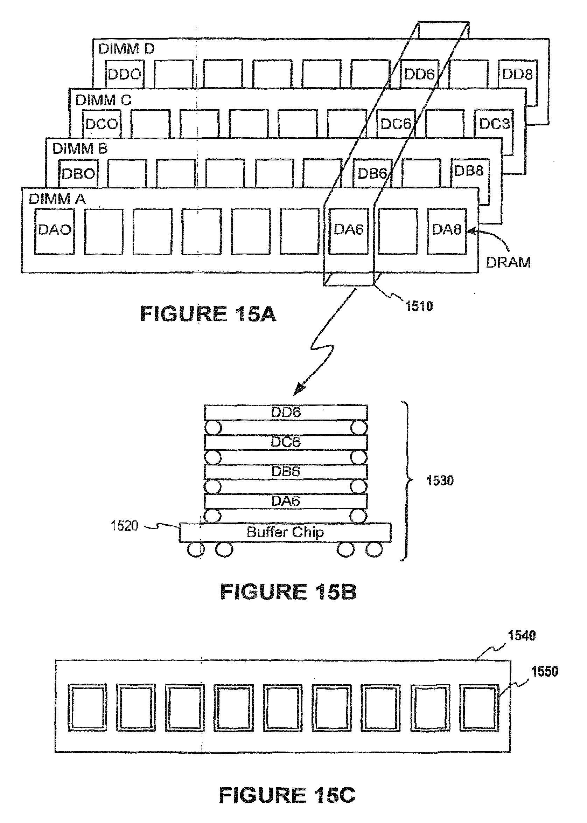

Figures **15A-15C** illustrate a DIMM with a plurality of DRAM stacks, in accordance with another embodiment. As an option, the DIMM may be implemented in the context of Figures **1-14****.** Of course, the DIMM may be implemented in any desired environment. Further, the aforementioned definitions may equally apply to the description below.

As shown, a DIMM with multiple DRAM stacks is provided, where each DRAM stack comprises a bit slice across multiple DIMMs. As an example, FIG. **15A** shows four DIMMs (e.g., DIMM A, DIMM B, DIMM C and DIMM D). Also, in this example, there are 9 bit slicers labeled DAO, ..., DA6,...DA8 across the four DIMMs. Bit slice "6" is shown encapsulated in block **1510.** **FIG. 15B** illustrates a buffered DRAM stack. The buffered DRAM stack **1530** comprises a buffer integrated circuit **(1520)** and DRAM devices DA6, DB6, DC6 and DD6. Thus, bit slice 6 is generated from devices DA6, DB6, DC6 and DD6. **FIG. 15C** is a top view of a high density DIMM with a plurality of buffered DRAM stacks. A high density DIMM **(1540)** comprises buffered DRAM stacks **(1550)** in place of individual DRAMs.

Some exemplary, embodiments include:

a configuration with increased DIMM density, that allows the total memory capacity of the system to increase without requiring a larger PCB area. Thus, higher density DIMMs fit within the mechanical and space constraints of current DIMMs;

a configuration with distributed power dissipation, which allows the higher density DIMM to fit within the thermal envelope of existing DIMMs. In an embodiment with multiple buffers on a single DIMM, the power dissipation of the buffering function is spread out across the DIMM; and

a configuration with non-cumulative latency to improve system performance. In a configuration with non-cumulative latency, the latency through the buffer integrated circuits on a DIMM is incurred only when that particular DIMM is being accessed.

In a buffered DRAM stack embodiment, the plurality of DRAM devices in a stack are electrically behind the buffer integrated circuit. In other words, the buffer integrated circuit sits electrically between the plurality of DRAM devices in the stack and the host electronic system and buffers some or all of the signals that pass between the stacked DRAM devices and the host system. Since the DRAM devices are standard, off-the-shelf, high speed devices (like DDR SDRAMs or DDR2 SDRAMs), the buffer integrated circuit may have to re-generate some of the signals (e.g. the clocks) while other signals (e.g. data signals) may have to be re-synchronized to the clocks or data strobes to minimize the jitter of these signals. Other signals (e.g. address signals) may be manipulated by logic circuits such as decoders. Some embodiments of the buffer integrated circuit may not re-generate or re-synchronize or logically manipulate some or all of the signals between the DRAM devices and host electronic system.

The buffer integrated circuit and the DRAM devices may be physically arranged in many different ways. In one embodiment, the buffer integrated circuit and the DRAM devices may all be in the same stack. In another embodiment, the buffer integrated circuit may be separate from the stack of DRAM integrated circuits (i.e. buffer integrated circuit may be outside the stack). In yet another embodiment, the DRAM integrated circuits that are electrically behind a buffer integrated circuit may be in multiple stacks (i.e. a buffer integrated circuit may interface with a plurality of stacks of DRAM integrated circuits).

In one embodiment, the buffer integrated circuit can be designed such that the DRAM devices that are electrically behind the buffer integrated circuit appear as a single DRAM integrated circuit to the host system, whose capacity is equal to the combined capacities of all the DRAM devices in the stack. So, for example, if the stack contains eight 512Mb DRAM integrated circuits, the buffer integrated circuit of this embodiment is designed to make the stack appear as a single 4Gb DRAM integrated circuit to the host system. An un-buffered DIMM, registered DIMM, SO-DIMM, or FB-DIMM can now be built using buffered stacks of DRAMs instead of individual DRAM devices. For example, a double rank registered DIMM that uses buffered DRAM stacks may have eighteen stacks, nine of which may be ion one side of the DIMM PCB and controlled by a first integrated circuit select signal from the host electronic system, and nine may be on the other side of the DIMM PCB and controlled by a second integrated circuit select signal from the host electronic system. Each of these stacks may contain a plurality of DRAM devices and a buffer integrated circuit.

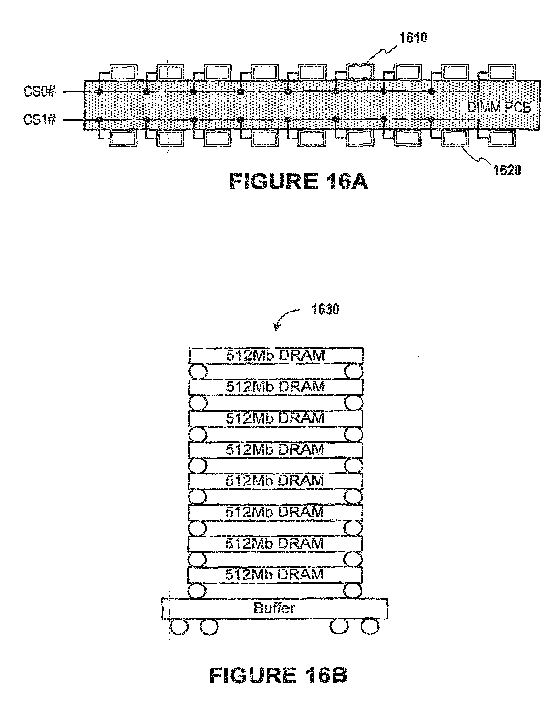

Figure **16A** illustrates a DIMM PCB with buffered DRAM stacks, in accordance with yet another embodiment. As an option, the DIMM PCB may be implemented in the context of Figures **1-15****.** Of course, the DIMM PCB may be implemented in any desired environment. Further, the aforementioned definitions may equally apply to the description below.

As shown, both the top and bottom sides of the DIMM PCB comprise a plurality of buffered DRAM stacks (*e.g*., **1610** and **1620).** Note that the register and clock PLL integrated circuits of a registered DIMM are not- shown in this figure for simplicity's sake.

Figure **16B** illustrates a buffered DRAM stack that emulates a 4 Gbyte DRAM, in accordance with still yet another embodiment. As an option, the buffered DRAM stack may be implemented in the context of Figures **1-16A****.** Of course, the buffered DRAM stack may ire implemented in any desired environment. Further, the aforementioned definitions may equally apply to the description below.

In one embodiment, a buffered stack of DRAM devices may appear as or emulate a single DRAM device to the host system. In such a case, the number of memory banks that are exposed to the host system may be less than the number of banks that are available in the stack. To illustrate, if the stack contained eight 512Mb DRAM integrated circuits, the buffer integrated circuit of this embodiment will make the stack look like a single 4Gb DRAM integrated circuit to the host system. So, even though there are thirty two banks (four banks per 512Mb integrated circuit * eight integrated circuits) in the stack, the buffer integrated circuit of this embodiment might only expose eight banks to the host system because a 4Gb DRAM will nominally have only eight banks. The eight 512Mb DRAM integrated circuits in this example may be referred to as physical DRAM devices while the single 4Gb DRAM integrated circuit may be referred to as a virtual DRAM device. Similarly, the banks of a physical DRAM device may be referred to as a physical bank whereas the bank of a virtual DRAM device may be referred to as a virtual bank.

In another embodiment of this invention, the buffer integrated circuit is designed such that a stack of n DRAM devices appears to the host system as m ranks of DRAM devices (where *n*>_*m,* and *m* >_*2)*. To illustrate, if the stack contained eight 512Mb DRAM integrated circuits, the buffer integrated circuit of this embodiment may make the stack appear as two ranks of 2Gb DRAM devices (for the case of m = 2), or appear as four ranks of I Gb'DRAM devices (for the **case** of m = 4), or appear as eight ranks of 512Mb DRAM devices (for the case of m = 8). Consequently, the stack of eight 512Mb DRAM devices may feature sixteen virtual banks (m = 2; eight banks per 2Gb virtual DRAM * two ranks); or thirty two virtual banks (m = 4; eight banks per 1Gb DRAM * four ranks), or thirty two banks (m = 8; four banks per 512Mb DRAM * eight ranks).

In one embodiment, the number of ranks may be determined by the number of integrated circuit select signals from the host system that are connected to the buffer integrated circuit. For example, the most widely used JEDEC approved pin out of a DIMM connector has two integrated circuit select signals. So, in this embodiment, each stack may be made to appear as two DRAM devices (where each integrated circuit belongs to a different rank) by routing the two integrated circuit select signals from the DIMM connector to each buffer integrated circuit on the D1MM. For the purpose of illustration, let us assume that each stack of DRAM devices has a dedicated buffer integrated circuit, and that the two integrated circuit select signals that are connected on the motherboard to a DIMM connector are labeled CSO# and CS I#. Let us also assume that each stack is 8-bits wide (*i. e*. has eight data pins), and that the stack contains a buffer integrated circuit and eight 8-bit wide 512Mb DRAM integrated circuits. In this example, both CSO# and CS 1# are connected to all the stacks on the DIMM. So, a single- sided registered DIMM with nine stacks (with CSO# and CS I# connected to all nine stacks) effectively features two 2GB ranks, where each rank has eight banks.

In another embodiment, a double-sided registered DIMM may be built using eighteen stacks (nine on each Side of the PCB), where each stack is 4-bits wide and contains a buffer integrated' circuit and eight 4-bit wide 512Mb DRAM devices. As above, if the two integrated circuit select signals CS0# and CS1# are connected to all the stacks, then this DIMM will effectively feature two 4GB ranks, where each rank has eight banks. However, half of a rank's capacity is on one side of the DIMM PCB and the other half is on the other side. For example, let us number the stacks on the DIMM as S0 through S 17, such that stacks S0 through S8 are on one side of the DIMM PCB while stacks S9 through S 17 are on the other side of the PCB. Stack S0 may be connected to the host system's data lines DQ[3:0], stack S9 connected to the host system's data lines DQ[7:4], stack S i to data lines DQ[11:8], stack S10 to data lines DQ[15:12], and so on. The eight 512Mb DRAM devices in stack S0 may be labeled as S0_M0 through S0_M7 and the eight 512Mb DRAM devices in stack S9 may be labeled as S9_M0 through S9_M7. In one example, integrated circuits S0_M0 through S0_M3 may be used by the buffer integrated circuit associated with stack S0 to emulate a 2Gb DRAM integrated circuit that belongs to the first rank (i.e. controlled by integrated circuit select CS0#). Similarly, integrated circuits S0_M4 through S0_M7 may be used by the buffer integrated circuit associated with stack S0 to emulate a 2Gb DRAM integrated circuit that belongs to the second rank (*i.e.* controlled by integrated circuit select CS1#). So, in general, integrated circuits S*n_*M0 through S*n*_M3 may be used to emulate a 2Gb DRAM integrated circuit that belongs to the first rank while integrated circuits S*n*_M4 through S*n_*M7 may be used to emulate a 2Gb DRAM integrated circuit that belongs to the second rank, where n represents the stack number (i.e. 0 ≤*n*≤17). It should be noted that the configuration described above is just for illustration. Other configurations may be used to achieve the same result without deviating from the spirit or scope of the claims. For example, integrated circuits S0_M0, S0_M2, S0 M4, and S0_M6 may be grouped together by the associated buffer integrated circuit to emulate a 2Gb DRAM integrated circuit in the first rank while integrated circuits S0_M1, S0_M3, S0_M5, and S0_M7 may be grouped together by the associated buffer integrated circuit to emulate a 2Gb DRAM integrated circuit in the second rank of the DIMM.

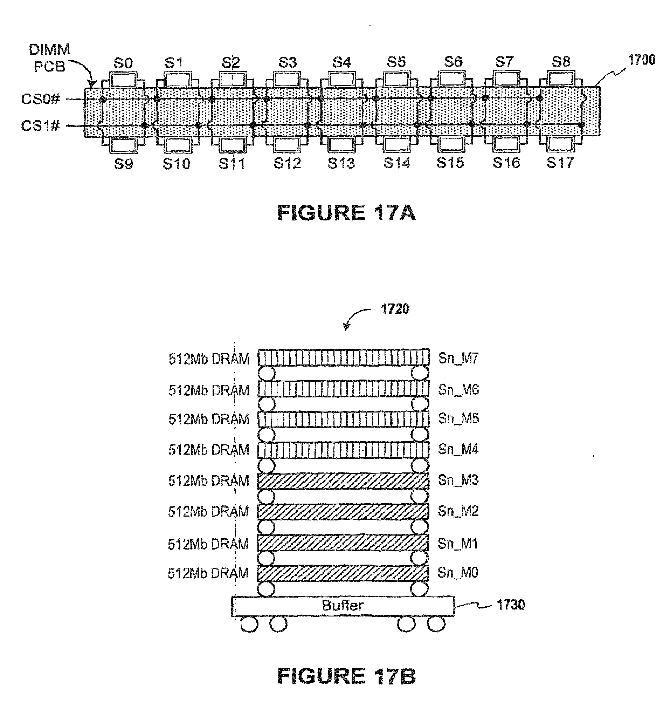

Figure **17A** illustrates an example of a DIMM that uses the buffer integrated circuit and DRAM stack, in accordance with another embodiment. As an option, the DIMM may be implemented in the context of Figures **1-16****.** Of course, the DIMM may be implemented in any desired environment. Further, the aforementioned definitions may equally apply to the description below.

For simplicity sake, note that the register and clock PLL integrated circuits of a registered DIMM are not shown. The DIMM PCB **1700** includes buffered DRAM stacks on the top side of DIMM PCB **1700** (e.g., S5) as well as the bottom side of DIMM PCB **1700** (e.g., S 15). Each buffered stack emulates two DRAMs.

Figure **17B** illustrates a physical stack of DRAMs in accordance with one embodiment, in accordance with yet another embodiment. As an option, the physical stack of DRAMs may be implemented in the context of Figures **1-17A****.** Of course, the physical stack of DRAMs may be implemented in any desired environment. Further, the aforementioned definitions may equally apply to the description below.

For example, stack **1720** comprises eight 4-bit wide, 512Mb DRAM devices and a buffer integrated circuit **1730.** As shown, a first group of devices, consisting of Sn_M0, Sn_M1, Sn_M2 and Sn_M3, is controlled by CS0#. A second group of devices, which consists of Sn_M4, Sn_M5, Sn_M6 and Sn_M7, is controlled by CS1#. It should be noted that the eight DRAM devices and the buffer integrated circuit are shown as belonging to one stack strictly as an example. Other implementations are possible. For example, the buffer integrated circuit **1730** may be outside the stack of DRAM devices. Also, the eight DRAM devices. Also, eight DRAM devices may be arranged in multiple stacks.

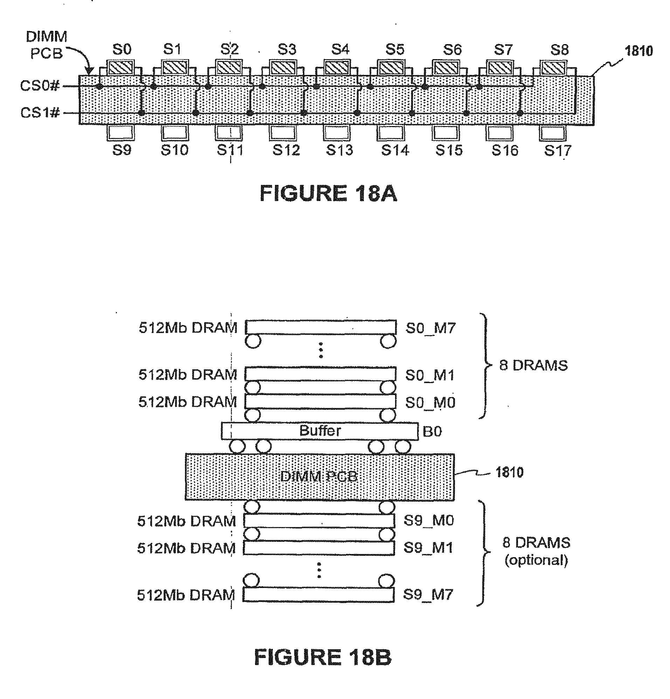

Figures **18A** and **18B** illustrate a multi-rank buffer integrated circuit and DIMM, in accordance with still yet another embodiment. As an option, the multi-rank buffer integrated circuit and DIMM may be implemented in the context of Figures **1-17****.** Of course, the multi-rank buffer integrated circuit and DIMM may be implemented in any desired environment. Further, the aforementioned definitions may equally apply to the description below.

In an optional variation of the multi-rank embodiment, a single buffer integrated circuit may be associated with a plurality of stacks of DRAM integrated circuits. In the embodiment exemplified in **FIGS. 18A** and **18B****,** a buffer integrated circuit is dedicated to two stacks of DRAM integrated circuits. **FIG. 18B** shows two stacks, one on each side of the DIMM PCB, and one buffer integrated circuit B0 situated on one side of the DIMM PCB. However, this is strictly for the purpose of illustration. The stacks that are associated with a buffer integrated circuit may be on the same side of the DIMM PCB or may be on both sides of the PCB.

In the embodiment exemplified in **FIGS. 18A** and **18B****,** each stack of DRAM devices contains eight 512Mb integrated circuits, the stacks are numbered S0 through S 17, and within each stack, the integrated circuits are labeled S*n_*M0 through S*n*_M7 (where *n* is 0 through 17). Also, for this example, the buffer integrated circuit is 8 -bits wide, and the buffer integrated circuits are numbered BO through B8. The two integrated circuit select signals, CS0# and CS1#, are connected to buffer BO as are the data lines DQ[7:0]. As shown, stacks S0 through S8 are the primary stacks and stacks S9 through S 17 are optional stacks. The stack S9 is placed on the other side of the DIMM PCB, directly opposite stack S0 (and buffer B0). The integrated circuits in stack S9 are connected to buffer B0. In other words, the DRAM devices in stacks S0 and S9 are connected to buffer B0, which in turn, is connected to the host system. In the case where the DIMM contains only the primary stacks S0 through S8, the eight DRAM devices in stack S0 are emulated by the buffer integrated circuit B0 to appear to the host system as two 2Gb devices, one of which is controlled by CS0# and the other is controlled by CS1#. In the case where the DIMM contains both the primary stacks S0 through S8 and the optional stacks S9 through S17, the sixteen 512Mb DRAM devices in stacks S0 and S9 i are together emulated by buffer integrated circuit B0 to appear to the host system as two 4Gb DRAM devices, one of which is controlled by CS0# and the other is controlled by CS1#.

It should be clear from the above description that this architecture decouples the electrical loading on the memory bus from the number of ranks. So, a lower density DIMM can be built with nine stacks (S0 through S 8) and nine buffer integrated circuits (B0 through B8), and a higher density DIMM can be built with eighteen stacks (S0 through S 17) and nine buffer integrated circuits (B0 through B8). It should be noted that it is not necessary to connect both integrated circuit select signals CS0# and CS1# to each buffer integrated circuit on the DIMM. A single rank lower density DIMM may be built with nine stacks (S0 through S8) and nine buffer integrated circuits (B0 through B8), wherein CS0# is connected to each buffer integrated circuit on the DIMM. Similarly, a single rank higher density DIMM may be built with seventeen stacks (S0 through S 17) and nine buffer integrated circuits, wherein CS0# is connected to each buffer integrated circuit on the DIMM.

A DIMM implementing a multi-rank embodiment using a multi-rank buffer is an optional feature for small form factor systems that have a limited number of DIMM slots. For example, consider a processor that has eight integrated circuit select signals, i and thus supports up to eight ranks. Such a processor may be capable of supporting four dual-rank DIMMs or eight single-rank DIMMs or any other combination that provides eight ranks. Assuming that each rank has y banks and that all the ranks are identical, this processor may keep up to *8*y* memory pages open at any given time. In some cases, a small form factor server like a blade or IU server may have physical space for only two DIMM slots per processor. This means that the processor in such a small form factor server may have open a maximum of *4*y* memory pages even though the processor is capable of maintaining *8*y* pages open. For such systems, a DIMM that contains stacks of DRAM devices and multi-rank buffer integrated circuits may be designed such that the processor maintains *8*y* memory pages open even though the number of DIMM slots in the system are fewer than the maximum number of slots that the processor may support. One way to accomplish this, is to apportion all the integrated circuit select signals of the host system across all the DIMM slots on the motherboard. For example, if the processor has only two dedicated DIMM slots, then four integrated circuit select signals may be connected to each DIMM connector. However, if the processor has four dedicated DIMM slots, then two integrated circuit select signals may be connected to each DIMM connector.

To illustrate the buffer and DIMM design, say that a buffer integrated circuit is designed to have up to eight integrated circuit select inputs that are accessible to the host system. Each of these integrated circuit select inputs may have a weak pull-up to a voltage between the logic high and logic low voltage levels of the integrated circuit select signals of the host system. F1Or example, the pull-up resistors may be connected to a voltage (VTT) midway between VDDQ and GND (Ground). These pull-up resistors may be on the DIMM PCB. Depending on the design of the motherboard, two or more integrated circuit select signals from the host system may be connected to the DIMM connector, and hence to the integrated circuit select inputs of the buffer integrated circuit. On power up, the buffer integrated circuit may detect a valid low or high logic level on some of its integrated circuit select inputs and may detect VTT on some other integrated circuit select inputs. The buffer integrated circuit may now configure the DRAMs in the stacks such that the number of ranks in the stacks matches the number of valid integrated circuit select inputs.

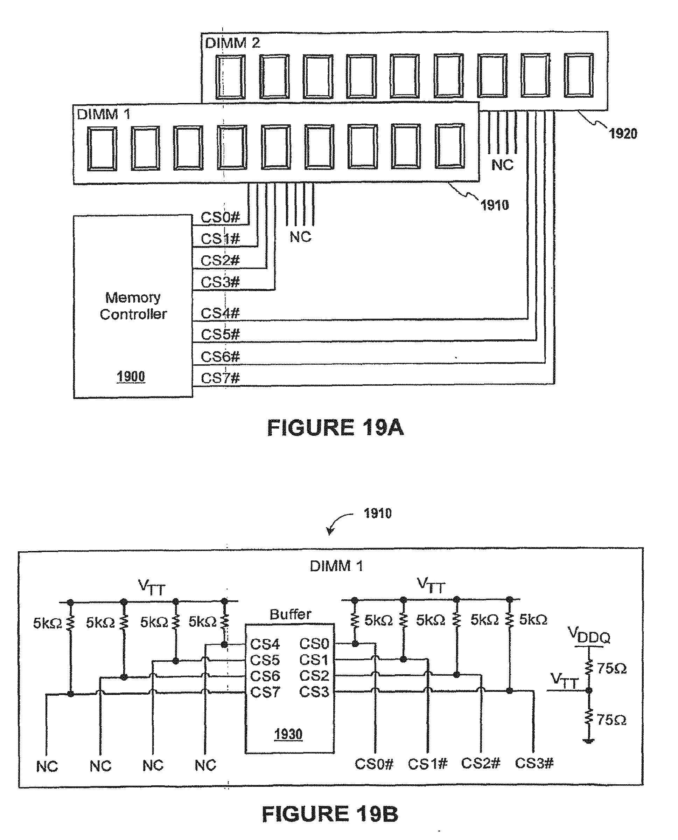

Figures **19A** and **19B** illustrate a buffer that provides a number of ranks on a DIMM equal to the number of valid integrated circuit selects from a host system, in accordance with another embodiment. As an option, the buffer may be implemented in the context of Figures **1-18****.** Of course, the buffer may be implemented in any desired i environment. Further, the aforementioned definitions may equally apply to the description below.

**FIG. 19A** illustrates a memory controller that connects to two DIMMS. Memory controller **(1900)** from the host system drives **8** integrated circuit select (CS) lines: CS0# through CS7#. The first four lines (CS0# - CS3#) are used to select memory ranks on a first DIMM **(1910),** and the second four lines (CS4# - CS7#) are used to select memory ranks on a second DIMM **(1920).** **FIG. 19B** illustrates a buffer and pull-up circuitry on a DIMM used to configure the number of ranks on a DIMM. For this example, buffer **1930** includes eight (8) integrated circuits select inputs (CS0# - CS7#). A pull-up circuit on DIMM **1910** pulls the voltage on the connected integrated circuit select lines to a midway voltage value (i.e., midway between VDDQ and GND, VTT). CS0# - CS3# are coupled to buffer **1930** via the pull-up circuit. CS4# - CS7# are not connected to DIMM **1910.** Thus, for this example, DIMM **1910** configures ranks based on the CS0# - CS3# lines.

Traditional motherboard designs hard wire a subset of the integrated circuit select signals to each DIMM connector. For example, if there are four DIMM connectors per processor, two integrated circuit select signals may be hard wired to each DIMM connector. However, for the case where only two of the four DIMM connectors are populated, only *4*y* memory banks are available even though the processor supports *8*y* banks because only two of the four DIMM connectors are populated with DIMMs. One method to provide dynamic memory bank availability is to configure a motherboard where all the integrated circuit select signals from the host system are connected to all the DIMM connectors on the motherboard. On power up, the host system queries the number of populated DIMM connectors in the system, and then apportions the integrated circuit selects across the populated connectors.

In one embodiment, the buffer integrated circuits may be programmed on each DEMM to respond only to certain integrated circuit select signals. Again, using the example above of a processor with four dedicated DIMM connectors, consider the case where only two of the four DIMM connectors are populated. The processor may be programmed to allocate the first four integrated circuit selects (e.g., CS0# through CS3#) to the first DIMM connector and allocate the remaining four integrated circuit selects (say, CS4# through CS7#) to the second DIMM connector. Then, the processor may instruct the buffer integrated circuits on the first DIMM to respond only to signals CS0# through CS3# and to ignore signals CS4# through CS7#. The processor may also instruct the buffer integrated circuits on the second DIMM to respond only to signals CS4# through CS7# and to ignore signals CS0# through CS3#. At a later time, if the remaining two DIMM connectors are populated, the processor may then re-program the buffer integrated circuits on the first DIMM to respond only to signals CS0# and CS1#, re-program the buffer integrated circuits on the second DIMM to respond only to signals CS2# and CS3#, program the buffer integrated circuits on the third DIMM to respond to signals CS4# and CS5#, and program the buffer integrated circuits on the fourth DIMM to respond to signals CS6# and CS7#. This approach ensures that the processor of this example is capable of maintaining *8*y* pages open irrespective of the number of DIMM connectors that are populated (assuming that each DIMM has the ability to support up to 8 memory ranks). In essence, this approach de-couples the number of open memory pages from the number of DIMMs in the system.

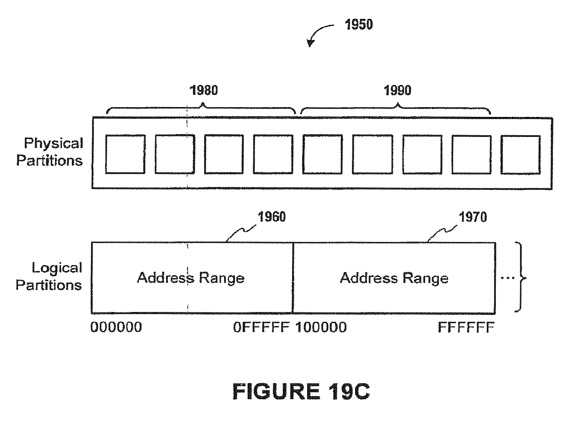

Figure **19C** illustrates a mapping between logical partitions of memory and physical partitions of memory, in accordance with yet another embodiment. As an option, the mapping may be implemented in the context of Figures **1-19****B.** Of course, the mapping may be implemented in any desired environment. Further, the aforementioned definitions may equally apply to the description below.

In an embodiment enabling multiple operating systems and software threads to run concurrently on a common hardware platform, the buffer integrated circuit may allocate a set of one or more memory devices in a stack to a particular operating system or software thread, while another set of memory devices may be allocated to other operating systems or threads. In the example of **FIG. 19C****,** the host system (not shown) may operate such that a first operating system is partitioned to a first logical address range **1960,** corresponding to physical partition **1980,** and all other operating systems are partitioned to a second logical address range **1970,** corresponding to a physical partition **1990.** On a context switch toward the first operating system or thread from another operating system or thread, the host system may notify the buffers on a DIMM or on multiple DIMMs of the nature of the context switch. This may be accomplished, for example, by the host system sending a command or control signal to the buffer integrated circuits either on the signal lines of the memory bus (i.e. in-band signaling) or on separate lines (i.e. side band signaling). An example of side band signaling would be to send a command to the buffer integrated circuits over an SMBus. The buffer integrated circuits may then place the memory integrated circuits allocated to the first operating system or thread **1980** in an active state while placing all the other memory integrated circuits allocated to other operating systems or threads **1990** (that are not currently being executed) in a low power or power down mode. This optional approach not only reduces the power dissipation in the memory stacks but also reduces accesses to the disk. For example, when the host system temporarily stops execution of an operating system or thread, the memory associated with the operating system or thread is placed in a low power mode but the contents are preserved. When the host system switches back to the operating system or thread at a later time, the buffer integrated circuits bring the associated memory out of the low power mode and into the active state and the operating system or thread may resume the execution from where it left off without having to access the disk for the relevant data. That is, each operating system or thread has a private main memory that is not accessible by other operating systems or threads. Note that this embodiment is applicable for both the single rank and the multi-rank buffer integrated circuits.

When users desire to increase the memory capacity of the host system, the normal method is to populate unused DIMM connectors with memory modules. However, when there are no more unpopulated connectors, users have traditionally removed the smaller capacity memory modules and replaced them with new, larger capacity memory modules. The smaller modules that were removed might be used on other host systems but typical 'practice is to discard them. Optionally, users may increase the memory capacity of a system that has no unpopulated DIMM connectors without having to discard the modules being currently used.

In one embodiment employing a buffer integrated circuit, a connector or some other interposer is placed on the DIMM, either on the same side of the DIMM PCB as the buffer integrated circuits or on the opposite side of the DIMM PCB from the buffer integrated circuits. When a larger memory capacity is desired, the user may mechanically and electrically couple a PCB containing additional memory stacks to the DIMM PCB by means of the connector or interposer. To illustrate, an example multi-rank registered DIMM may have nine 8-bit wide stacks, where each stack contains a plurality of DRAM devices and a multi-rank buffer. For this example, the nine stacks may reside on one side of the DIMM PCB, and one or more connectors or interposers may reside on the other side of the DIMM PCB. The capacity of the DIMM may now be increased by mechanically and electrically coupling an additional PCB containing stacks of DRAM devices to the DIMM PCB using the connector(s) or interposer(s) on the DIMM PCB. For this embodiment, the multi-rank buffer integrated circuits on the DIMM PCB may detect the presence of the additional stacks and configure themselves to use the additional stacks in one or more configurations employing the additional stacks. It should be noted that it is not necessary for the stacks on the additional PCB to have the same memory capacity as the stacks on the DIMM PCB. In addition, if the stacks on the DIMM PCB may be connected to one integrated circuit select signal while the stacks on the additional PCB may be connected to another integrated circuit select signal. Alternately, the stacks on the DEMM PCB and the stacks on the additional PCB may be connected to the same set of integrated circuit select signals.

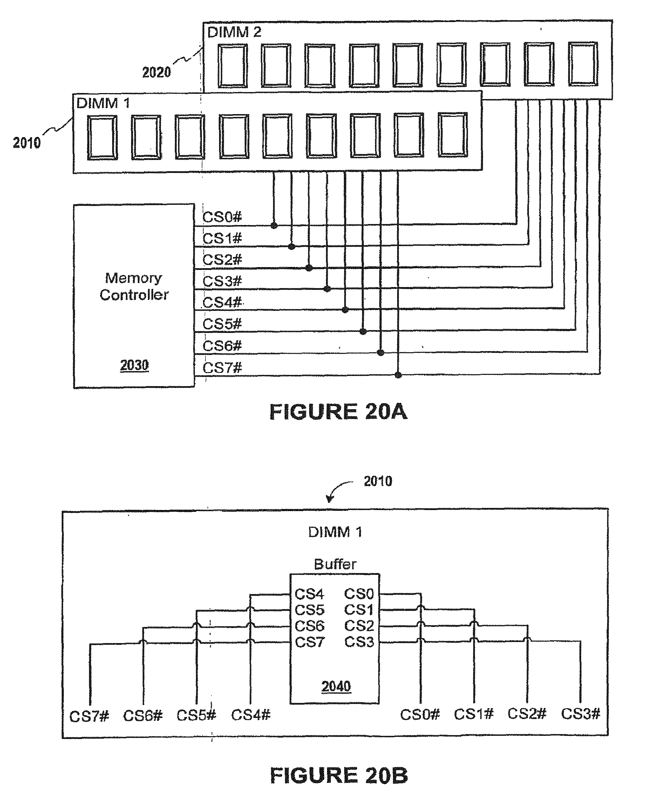

Figure **20A** illustrates a configuration between a memory controller and DIMMs, in accordance with still yet another embodiment. As an option, the memory controller and DIMMs may be implemented in the context of **Figures 1-19**. Of course, the memory controller and DIMMs may be implemented in any desired environment. Further, the aforementioned definitions may equally apply to the description below.

FIGS. **20A** illustrates a memory system that configures the number of ranks in a DIMM based on commands from a host system. For this embodiment, all the integrated circuit select lines (e.g., CSC># - CS7#) are coupled between memory controller **2030** and DIMMs **2010** and **2020.**

Figure **20B** illustrates the coupling of integrated circuit select lines to a buffer on a DIMM for configuring the number of ranks based on commands from the host system, in accordance with another embodiment. As an option, the coupling of integrated circuit select lines to a buffer on a DIMM may be implemented in the context of Figures **1-20A****.** Of course, the coupling of integrated circuit select lines to a buffer on a DIMM may be implemented in any desired environment. Further, the aforementioned definitions may equally apply to the description below.

FIG. **20B** illustrate a memory system that configures the number of ranks in a DIMM based on commands from a host system. For this embodiment, all integrated circuit select lines (CS0# - CS7#) are coupled to buffer **2040** on DIMM **2010.**

Virtualization and multi-core processors are enabling multiple operating systems and software threads to run concurrently on a common hardware platform. This means that multiple operating systems and threads must share the memory in the server, and the resultant context switches could result in increased transfers between the hard disk and memory.

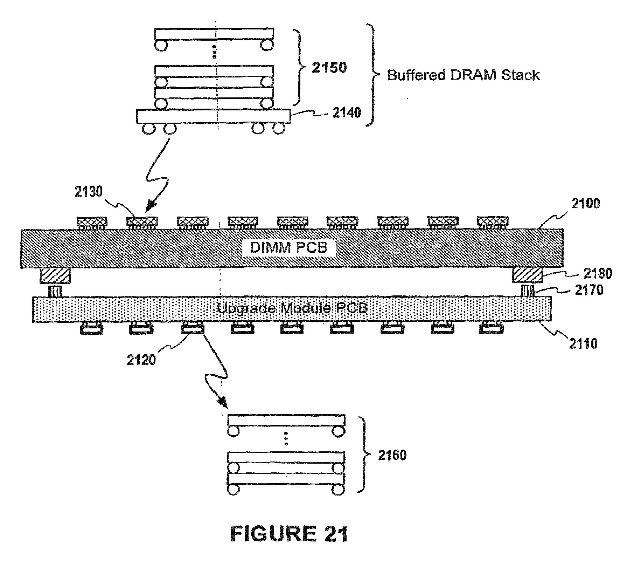

Figure **21** illustrates a DIMM PCB with a connector or interposer with upgrade capability, in accordance with yet another embodiment. As an option, the DIMM PCB may be implemented in the context of Figures **1-20****.** Of course, the DIMM PCB may be implemented in any desired environment. Further, the aforementioned definitions may equally apply to the description below.

A DIMM PCB **2100** comprises a plurality of buffered stacks, such as buffered stack **2130.** As shown, buffered stack **2130** includes buffer integrated circuit **2140** and DRAM devices **2150.** An upgrade module PCB **2110,** which connects to DIMM PCB **2100** via connector or interposer **2180** and **2170,** includes stacks of DRAMs, such as DRAM stack **2120.** In this example and as shown in **FIG. 21****,** the upgrade module PCB **2110** contains nine 8-bit wide stacks, wherein each stack contains only DRAM integrated circuits **2160.** Each multi-rank buffer integrated circuit **2140** on DIMM PCB **2100,** upon detection of the additional stack, re-configures itself such that it sits electrically between the host system and the two stacks of DRAM integrated circuits. That is, the buffer integrated circuit is now electrically between the host system and the stack on the DIMM PCB **2100** as well as the corresponding stack on the upgrade module PCB **2110.** However, it should be noted that other embodiments of the buffer integrated circuit **(2140),** the DRAM stacks **(2120),** the DIMM PCB **2100,** and the upgrade module PCB **2110** may be configured in various manners to achieve the same result, without deviating from the spirit or scope of the claims. For example, the stack **2120** on the additional PCB may also contain a buffer integrated circuit. So, in this example, the upgrade module **2110** i may contain one or more buffer integrated circuits.

The buffer integrated circuits may map the addresses from the host system to i the DRAM devices in the stacks in several ways. In one embodiment, the addresses may be mapped in a linear fashion, such that a bank of the virtual (or emulated) DRAM is mapped to a set of physical banks, and wherein each physical bank in the set is part of a different physical DRAM device. To illustrate, let us consider a stack containing eight 512Mb DRAM integrated circuits (i.e. physical DRAM devices), each of which has four memory banks. Let us also assume that the buffer integrated circuit is the multi-rank i embodiment such that the host system sees two 2Gb DRAM devices (i.e. virtual DRAM devices), each of which has eight banks. If we label the physical DRAM devices M0 through M7, then a linear address map may be implemented as shown in Table 1 below.

**Table 1**

| Host System Address (Virtual Bank) | DRAM Device (Physical Bank) |
|---|---|
| Rank 0, Bank [0] | {(M4, Bank [0]), (M0, Bank [0])} |
| Rank 0, Bank [1] | {(M4, Bank [1]), (M0, Bank [1])} |
| Rank 0, Bank [2] | {(M4, Bank [2]), (M0, Bank [2])} |
| Rank 0, Bank [3] | {(M4, Bank [3]), (M0, Bank [3])} |
| Rank 0, Bank [4] | {(M6, Bank [0]), (M2, Bank [0])} |
| Rank 0, Bank [5] | {(M6, Bank [1]), (M2, Bank [1])} |
| Rank 0, Bank [6] | {(M6, Bank [2]), (M2, Bank [2])} |
| Rank 0, Bank [7] | {(M6, Bank [3]), (M2, Bank [3])} |
| Rank 1, Bank [0] | {(M5, Bank [0]), (M1, Bank [0])} |
| Rank 1, Bank [1] | {(M5, Bank [1]), (M1, Bank [1])} |
| Rank 1, Bank [2] | {(M5, Bank [2]), (M1, Bank [2])} |
| Rank 1, Bank [3] | {(M5, Bank [3]), (M1, Bank [3])} |
| Rank 1, Bank [4] | {(M7, Bank [0]), (M3, Bank [0])} |
| Rank 1, Bank [5] | {(M7, Bank [1]), (M3, Bank [1])} |
| Rank 1, Bank [6] | {(M7, Bank [2]), (M3, Bank [2])} |
| Rank 1, Bank [7] | {(M7, Bank [3]), (M3, Bank [3])} |

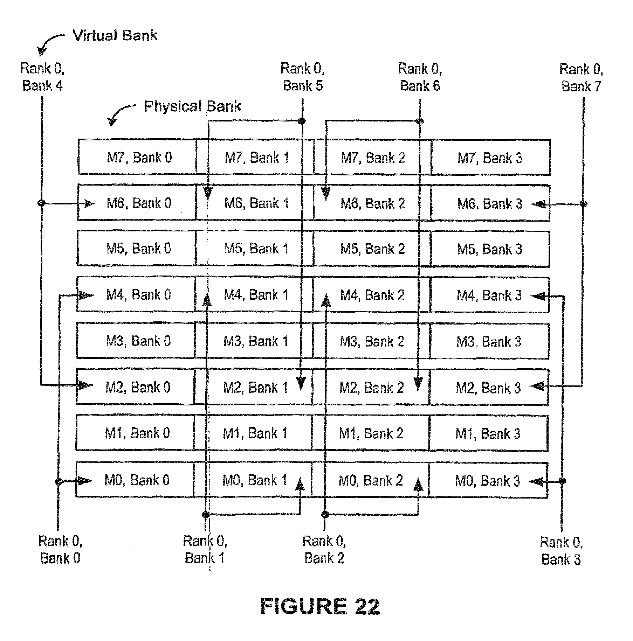

Figure **22** illustrates an example of linear address mapping for use with a multi-rank buffer integrated circuit, in accordance with still yet another embodiment. As an option, the linear address mapping may be implemented in the context of Figures **1-21****.** Of course, the linear address mapping may be implemented in any desired environment. Further, the aforementioned definitions may equally apply to the description below.

An example of a linear address mapping with a single-rank buffer integrated circuit is shown in Table 2 below.

**Table 2**

| Host System Address (Virtual Bank) | DRAM Device (Physical Banks) |
|---|---|
| Rank 0, Bank [0] | {(M6, Bank [0]), (M4, Bank[0]), (M2, Bank [0]), (M0, Bank [0])} |
| Rank 0, Bank [1] | {(M6, Bank [1]), (M4, Bank[1]), (M2, Bank [1]), (M0, Bank [1])} |
| Rank 0, Bank [2] | {(M6, Bank [2]), (M4, Bank[2]), (M2, Bank [2]), (M0, Bank [2])} |
| Rank 0, Bank [3] | {(M6, Bank [3]), (M4, Bank[3]), (M2, Bank [3]), (M0, Bank [3])} |
| Rank 0, Bank [4] | {(M7, Bank [0]), (M5, Bank[0]), (M3, Bank [0]), (M1, Bank [0])} |
| Rank 0, Bank [5] | {(M7, Bank [1]), (M5, Bank[1]), (M3, Bank [1]), (M1, Bank [1])} |
| Rank 0, Bank [6] | {(M7, Bank [2]), (M5, Bank[2]), (M3, Bank [2]), (M1, Bank [2])} |
| Rank 0, Bank [7] | {(M7, Bank [3]), (M5, Bank[3]), (M3, Bank [3]), (M1, Bank [3])} |

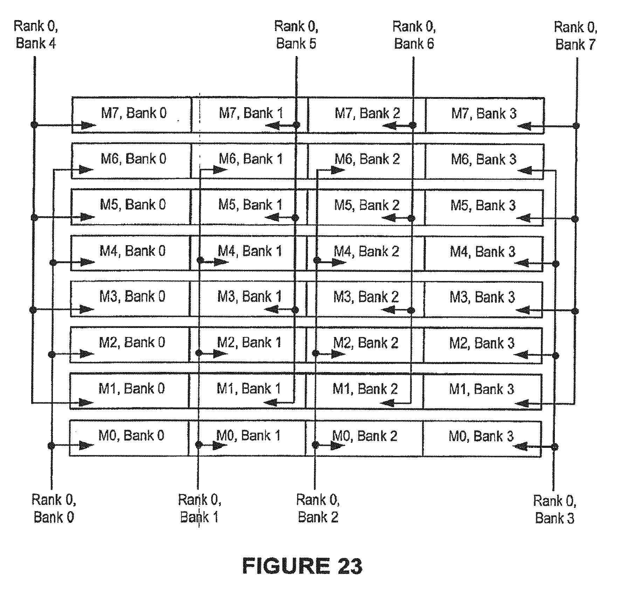

Figure **23** illustrates an example of linear address mapping with a single rank buffer integrated circuit, in accordance with another embodiment. As an option, the linear address mapping may be implemented in the context of Figures **1-22****.** Of course, the linear address mapping may be implemented in any desired environment. Further, the aforementioned definitions may equally apply to the description below.

Using the configuration shown, the stack of DRAM devices appears as a single 4Gb integrated circuit with eight memory banks.

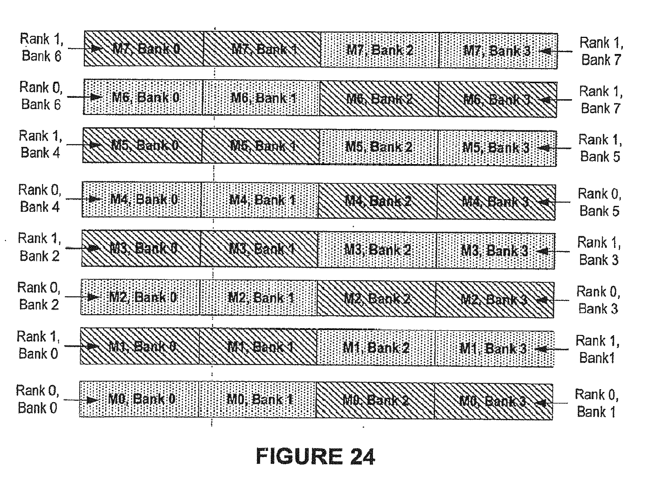

Figure **24** illustrates an example of "bit slice" address mapping with a multi- rank buffer integrated circuit,} in accordance with yet another embodiment. As an option, the "bit slice" address mapping may be implemented in the context of Figures **1-23**. Of course, the "bit slice" address, mapping may be implemented in any desired environment. Further, the aforementioned definitions may equally apply to the description below.

In another embodiment, the addresses from the host system may be mapped by the buffer integrated circuit such that one or more banks of the host system address (i.e. virtual banks) are mapped to a single physical DRAM integrated circuit in the stack ("bank slice" mapping). **FIG. 24** illustrates an example of bank slice address mapping with a multi-rank buffer integrated circuit. Also, an example of a bank slice address mapping is shown in Table 3 below.

**Table 3**

| Host System Address (Virtual Bank) | DRAM Device (Physical Bank) |
|---|---|
| Rank 0, Bank [0] | M0, Bank [1:0] |
| Rank 0, Bank [1] | M0, Bank [3:2] |
| Rank 0, Bank [2] | M2, Bank [1:0] |
| Rank 0, Bank [3] | M2, Bank [3:2] |
| Rank 0, Bank [4] | M4, Bank [1:0] |
| Rank 0, Bank [5] | M4, Bank [3:2] |
| Rank 0, Bank [6] | M6, Bank [1:0] |
| Rank 0, Bank [7] | M6, Bank [3:2] |
| Rank 1, Bank [0] | M1, Bank [1:0] |
| Rank 1, Bank [1] | M1, Bank [3:2] |
| Rank 1, Bank [2] | M3, Bank [1:0] |
| Rank 1, Bank [3] | M3, Bank [3:2] |
| Rank 1, Bank [4] | M5, Bank [1:0] |
| Rank 1, Bank [5] | M5, Bank [3:2] |
| Rank 1, Bank [6] | M7, Bank [1:0] |
| Rank 1, Bank [7] | M7, Bank [3:2] |

The stack of this example contains eight 512Mb DRAM integrated circuits, each with four memory banks. In this example, a multi-rank buffer integrated circuit is assumed, which means that the host system sees the stack as two 2Gb DRAM devices, each having eight banks.

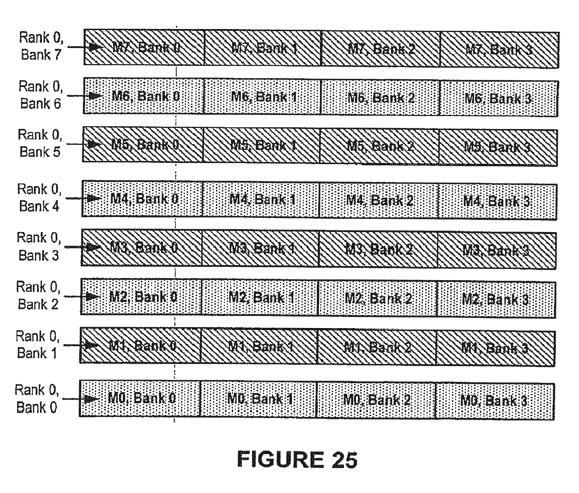

Bank slice address mapping enables the virtual DRAM to reduce or eliminate some timing constraints that are inherent in the underlying physical DRAM devices. For instance, the physical DRAM devices may have a tFAW (4 bank activate window) constraint that limits how frequently an activate operation may be targeted to a physical DRAM device. However, a virtual DRAM circuit that uses bank slice address mapping may not have this constraint. As an example, the address mapping in **FIG. 24** maps two banks of the virtual DRAM device to a single physical DRAM device. So, the tFAW constraint is eliminated because the t_{Rc} timing parameter prevents the host system from issuing more than two consecutive activate commands to any given physical DRAM i device within a t_{R}c window (and t_{Rc}>t_{FAw})- Similarly, a virtual DRAM device that uses the address mapping, as described below with respect to in **FIG. 25** eliminates the T_{RRD} constraint of the underlying physical DRAM devices.

Figure **25** illustrates an example of "bit slice" address mapping with a single rank buffer integrated circuit, in accordance with still yet another embodiment. As an option, the "bit slice" address mapping may be implemented in the context of Figures **1-24****.** Of course, the "bit slice" address mapping may be implemented in any desired environment. Further, the aforementioned definitions may equally apply to the description below.

The bank slice mapping with a single-rank buffer integrated circuit is shown in Table 3 below.

**Table 3**

| Host System Address (Virtual Bank) | DRAM Device (Physical Device) |
|---|---|
| Rank 0, Bank [0] | M0 |
| Rank 0, Bank [1] | M1 |
| Rank 0, Bank [2] | M2 |
| Rank 0, Bank [3] | M3 |
| Rank 0, Bank [4] | M4 |
| Rank 0, Bank [5] | M5 |
| Rank 0, Bank [6] | M6 |
| Rank 0, Bank [7] | M7 |

The stack of this example contains eight 512Mb DRAM devices so that the host system sees the stack as a single 4Gb device with eight banks. The address mappings shown above are for illustrative purposes only. Other mappings may be implemented without deviating from the spirit and scope of the claims.

In addition, a bank slice address mapping scheme enables the buffer integrated circuit or the host system to power manage the DRAM devices on a DIMM on a more granular level. To illustrate this, consider a virtual DRAM device that uses the address mapping shown in **FIG. 25****,** where each bank of the virtual DRAM device corresponds to a single physical DRAM device. So, when bank 0 of the virtual DRAM device (i.e. virtual bank 0) is accessed, the corresponding physical DRAM device M0 may be in the active mode. However, when there is no outstanding access to virtual bank 0, the buffer i integrated circuit or the host system (or any other entity in the system) may place DRAM device M0 in a low power (e.g. power down) mode. While it is possible to place a physical DRAM device in a low power mode, it is not possible to place a bank (or portion) of a physical DRAM device in a low power mode while the remaining banks (or portions) of the DRAM device are in the active mode. However, a bank or set of banks of a virtual DRAM circuit may be placed in a low power mode while other banks of the virtual DRAM circuit are in 'the active mode since a plurality of physical DRAM devices are used to emulate a virtual DRAM device. It can be seen from **FIG. 25** and **FIG. 23****,** for example, that fewer virtual banks are mapped to a physical DRAM device with bank slice mapping **(****FIG.25****)** than with linear mapping (**FIG. 23****).** Thus, the likelihood that all the (physical) banks in a physical DRAM device are in the precharge state at any given time is higher with bank slice mapping than with linear mapping. Therefore, the buffer integrated circuit or the host system (or some other entity in the system) has more opportunities to place various physical DRAM devices in a low power mode when bank slide mapping is used.

In several market segments, it may be desirable to preserve the contents of main memory (usually, DRAM) either periodically or when certain events occur. For example, in the supercomputer market, it is common for the host system to periodically write the contents of main memory to the hard drive. That is, the host system creates periodic checkpoints. This method of checkpointing enables the system to re-start program execution from the last checkpoint instead of from the beginning in the event of a system crash. In other markets, it may be desirable for the contents of one or more address ranges to be periodically stored in non-volatile memory to protect against power failures or system crashes. All these features may be optionally implemented in a buffer integrated circuit disclosed herein by integrating one or more non-volatile memory integrated circuits (e.g. flash memory) into the stack. In some embodiments, the buffer integrated circuit is designed to interface with one or more stacks containing DRAM devices and non-volatile memory integrated circuits. Note that each of these stacks may contain only DRAM devices or contain only non-volatile memory integrated circuits or contain a mixture of DRAM and non-volatile memory integrated circuits.

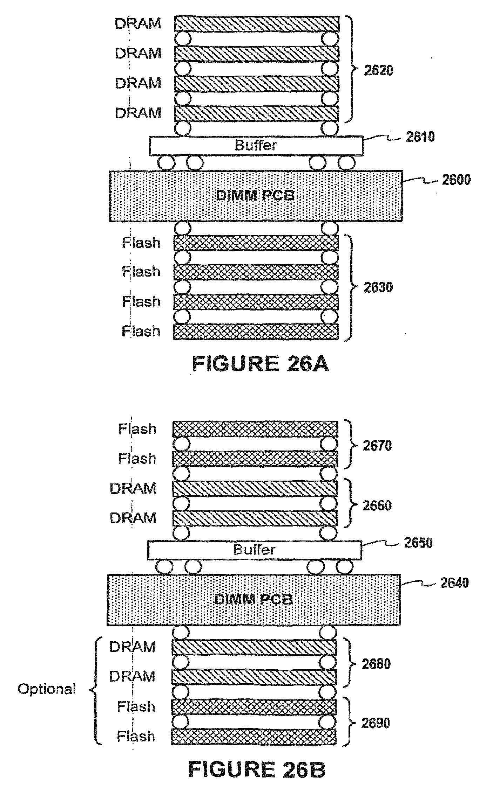

Figures **26A** and **26B** illustrate examples of buffered stacks that contain DRAM and non- volatile memory integrated circuits, in accordance with another embodiment. As an option, the buffered stacks may be implemented in the context of Figures **1-25****.** Of course, the' buffered stacks may be implemented in any desired environment. Further, the aforementioned definitions may equally apply to the description below.

A DIMM PCB **2600** includes a buffered stack (buffer **2610** and DRAMs **2620)** and flash **2630.** In another embodiment shown in **FIG. 26B****,** DIMM PCB **2640** includes a buffered stack (buffer **2650,** DRAMs **2660** and flash **2670).** An optional non- buffered stack includes at least one non-volatile memory device (e.g., flash **2690)** or DRAM device **2680.** All the stacks that connect to a buffer integrated circuit may be on the same PCB as the buffer integrated circuit or some of the stacks may be on the same PCB while other stacks may be on another PCB that is electrically and mechanically coupled by means of a connector or an interposer to the PCB containing the buffer integrated circuit.

In some embodiments, the buffer integrated circuit copies some or all of the contents of the DRAM devices in the stacks that it interfaces with to the non-volatile memory integrated circuits in the stacks that it interfaces with. This event may be triggered, for example, by a command or signal from the host system to the buffer integrated circuit, by an external signal to the buffer integrated circuit, or upon the detection (by the buffer integrated circuit) of an event or a catastrophic condition like a power failure. As an example, let us assume that a buffer integrated circuit interfaces with a plurality of stacks that contain 4Gb of DRAM memory and 4Gb of non-volatile memory. The host system may periodically issue a command to the buffer integrated circuit to copy the contents of the DRAM memory to the non- volatile memory. That is, the host system periodically checkpoints the contents of the DRAM memory. In the event of a system crash, the contents of the DRAM may be restored upon re-boot by copying the contents of the non-volatile memory back to the DRAM memory. This provides the host system with the ability to periodically check point the memory.

In another embodiment, the buffer integrated circuit may monitor the power supply rails (i.e. voltage rails, or voltage planes) and detect a catastrophic event, for example, a power supply failure. Upon detection of this event, the buffer integrated circuit may copy some or all the contents of the DRAM memory to the non-volatile memory. The host system may also provide a non-interruptible source of power to the buffer integrated circuit and the memory stacks for at least some period of time after the power supply failure to allow the buffer integrated circuit to copy some or all the contents of the DRAM memory to the non-volatile memory. In other embodiments, the memory module may have a built-in backup source of power for the buffer integrated circuits and the memory stacks in the event of a host system power supply failure. For example, the memory module may have a battery or a large capacitor and an isolation switch on the module itself to provide backup power to the buffer integrated circuits and the memory stacks in the event of a host system power supply failure.

A memory module, as described above, with a plurality of buffers, each of which interfaces to one or more stacks containing DRAM and non-volatile memory integrated circuits, may also be configured to provide instant-on capability. This may be accomplished by storing the operating system, other key software, and frequently used data in the non-volatile memory.

In the event of a system crash, the memory controller of the host system may not be able to supply all the necessary signals needed to maintain the contents of main memory. For example, the memory controller may not send periodic refresh commands to the main memory, thus causing the loss of data in the memory. The buffer integrated circuit may be designed to prevent such loss of data in the event of a system crash. In one embodiment, the buffer integrated circuit may monitor the state of the signals from the memory controller of the host system to detect a system crash. As an example, the buffer integrated circuit may be designed to detect a system crash if there has been no activity on the memory bus for a pre-determined or programmable amount of time or if the buffer integrated circuit receives an illegal or invalid command from the memory controller. Alternately, the buffer integrated circuit may monitor one or more signals that are asserted when a system error or system halt or system crash has occurred. For example, the buffer integrated circuit may monitor the *HT_SyncFlood* signal in an Opteron processor based system to detect a system error. When the buffer integrated circuit detects this event, it may de-couple the memory bus of the host system from the memory integrated circuits in the stack and internally generate the signals needed to preserve the contents of the memory integrated circuits until such time as the host system is operational. So, for example, upon detection of a system crash, the buffer integrated circuit may ignore the signals from the memory controller of the host system and instead generate legal combinations of signals like CKE, CS#, RAS#, CAS#, and WE# to maintain the data stored in the DRAM devices in the stack, and also generate periodic refresh signals for the DRAM integrated circuits. Note that there are many ways for the buffer integrated circuit to detect a system crash, and all these variations fall within the scope of the claims.

Placing a buffer integrated circuit between one or more stacks of memory integrated circuits and the host system allows the buffer integrated circuit to compensate for any skews or timing variations in the signals from the host system to the memory integrated circuits and from the memory integrated circuits to the host system. For example, at higher speeds of operation of the memory bus, the trace lengths of signals between the memory controller of the host system and the memory integrated circuits are often matched. Trace length matching is challenging especially in small form factor systems. Also, DRAM processes do not readily lend themselves to the design of high speed I/O circuits. Consequently, it is often difficult to align the I/O signals of the DRAM integrated circuits with each other and with the associated data strobe and clock signals.

In one embodiment of a buffer integrated circuit, circuitry that adjusts the timing of the I/O signals may be incorporated. In other words, the buffer integrated circuit may have the ability to do per-pin timing calibration to compensate for skews or timing i variations in the I/O signals. For example, say that the DQ[0] data signal between the buffer integrated circuit and pie memory controller has a shorter trace length or has a smaller capacitive load than the other data signals, DQ[7:1]. This results in a skew in the data signals since not all the signals arrive at the buffer integrated circuit (during a memory write) or at the memory controller (during a memory read) at the same time. When left uncompensated, such skews tend to limit the maximum frequency of operation of the memory sub-system of the host system. By incorporating per-pin timing calibration and compensation circuits into the I/O circuits of the buffer integrated circuit, the DQ[0] signal may be driven later than the other data signals by the buffer integrated circuit (during a memory read) to compensate for the shorter trace length of the DQ[0] signal. Similarly, the per-pin timing calibration and compensation circuits allow the buffer integrated circuit to delay the DQ[0] data signal such that all the data signals, DQ[7:0], are aligned for sampling during a memory write operation. The per-pin timing calibration and compensation circuits also allow the buffer integrated circuit to compensate for timing variations in the I/O pins of the DRAM devices. A specific pattern or sequence may be used by the buffer integrated circuit to perform the per-pin timing calibration of the signals that connect to the memory controller of the host system and the per-pin timing calibration of the signals that connect to the memory devices in the stack.

Incorporating per/pin timing calibration and compensation circuits into the buffer integrated circuit also enables the buffer integrated circuit to gang a plurality of slower DRAM devices to emulate a higher speed DRAM integrated circuit to the host system. That is, incorporating per-pin timing calibration and compensation circuits into the buffer integrated circuit also enables the buffer integrated circuit to gang a plurality of DRAM devices operating at a first clock speed and emulate to the host system one or more DRAM integrated circuits operating at a second clock speed, wherein the first clock speed is slower than the second clock speed.

For example, the buffer integrated circuit may operate two 8-bit wide DDR2 SDRAM devices in parallel at a 533MHz data rate such that the host system sees a single 8-bit wide DDR2 SDRAM integrated circuit that operates at a 1066MHz data rate. Since, in this example, the two DRAM devices are DDR2 devices, they are designed to transmit or receive four data bits on each data pin for a memory read or write respectively (for a burst length of 4). So, the two DRAM devices operating in parallel may transmit or receive sixty four bits per data pin per memory read or write respectively in this example. Since the host system sees a single DDR2 integrated circuit behind the buffer, it will only receive or transmit thirty-two data bits per pin per memory read or write respectively. In order to accommodate for the different data widths, the buffer integrated circuit may make use of the DM signal (Data Mask). Say that the host system sends DA[7:0], DB[7:0], DC[7:0], and DD[7:0] to the buffer integrated circuit at a 1066MHz data rate. The buffer integrated circuit may send DA[7:0], DC[7:0], XX, and XX to the first DDR2 SDRAM integrated circuit and send DB[7:0], DD[7:0], XX, and XX to the second DDR2 SDRAM integrated circuit, where XX denotes data that is masked by the assertion (by the buffer integrated circuit) of the DM inputs to the DDR2 SDRAM integrated circuits.

In another embodiment, the buffer integrated circuit operates two slower DRAM devices as a single, higher-speed, wider DRAM. To illustrate, the buffer integrated circuit may operate two 8-bit wide DDR2 SDRAM devices running at 533MHz data rate such that the host system sees a single 16-bit wide DDR2 SDRAM integrated circuit operating at a 1066MHz data rate. In this embodiment, the buffer integrated circuit may not use the *DM* signals. In another embodiment, the buffer integrated circuit may be designed to operate two DDR2 SDRAM devices (in this example, 8-bit wide, 533MHz data rate integrated circuits) in parallel, such that the host system sees a single DDR3 SDRAM integrated circuit (in this example, an 8-bit wide, 1066MHz data rate, DDR3 device). In another embodiment, the buffer integrated circuit may provide an interface to the host system that is narrower and faster than the interface to the DRAM integrated circuit. For example, the buffer integrated circuit may have a 16- bit wide, 533MHz data rate interface to one or more DRAM devices but have an 8-bit wide, 1066MHz data rate interface to the host system.

In addition to per-pin timing calibration and compensation capability, circuitry to control the slew rate (*i.e.* the rise and fall times), pull-up capability or strength, and pull-down capability or strength may be added to each I/O pin of the buffer integrated circuit or optionally, in common to a group of I/O pins of the buffer integrated circuit. The output drivers and the input receivers of the buffer integrated circuit may have the ability to do pre-emphasis in order to compensate for non-uniformities in the traces connecting the buffer integrated circuit to the host system and to the memory integrated circuits in the stack, as well as to compensate for the characteristics of the I/O pins of the host system and the memory, integrated circuits in the stack.

Stacking a plurality of memory integrated circuits (both volatile and nonvolatile) has associated thermal and power delivery characteristics. Since it is quite possible that all the memory integrated circuits in a stack may be in the active mode for extended periods of time, the power dissipated by all these integrated circuits may cause an increase in the ambient, case, and junction temperatures of the memory integrated circuits. Higher junction temperatures typically have negative impact on the operation of ICs in general and DRAMs in particular. Also, when a plurality of DRAM devices are stacked on top of each other such that they share voltage and ground rails (i.e. power and ground traces or planes), any simultaneous operation of the integrated circuits may cause large spikes in the voltage and ground rails. For example, a large current may be drawn from the voltage rail when all the DRAM devices in a stack are refreshed simultaneously, thus causing a significant disturbance (or spike) in the voltage and ground rails. Noisy voltage and ground rails affect the operation of the DRAM devices especially at high speeds. In order to address both these phenomena, several inventive techniques are disclosed below.

One embodiment uses a stacking technique wherein one or more layers of the stack have decoupling capacitors rather than memory integrated circuits. For example, every fifth layer in the stack may be a power supply decoupling layer (with the other four layers containing memory integrated circuits). The layers that contain memory integrated circuits are designed with more power and ground balls or pins than are present in the pin out of the memory integrated circuits. These extra power and ground balls are preferably disposed along all the edges of the layers of the stack.

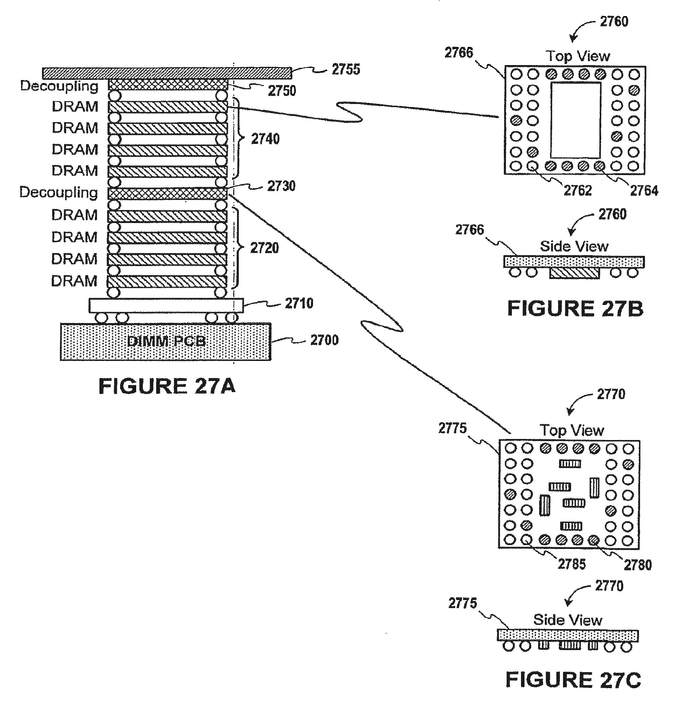

Figures **27A, 27B** and **27C** illustrate a buffered stack with power decoupling layers, in accordance with yet another embodiment. As an option, the buffered stack may be implemented in the content of Figures **1-26****.** Of course, the buffered stack may be implemented in any desired environment. Further, the aforementioned definitions may equally apply to the description below.

As shown in **FIG; 27A****,** DIMM PCB **2700** includes a buffered stack of DRAMs including decoupling layers. Specifically, for this embodiment, the buffered stack includes buffer **2710,** a first set of DRAM devices **2720,** a first decoupling layer **2730,** a second set of DRAM devices **2740,** and an optional second decoupling layer **2750.** The stack also has an optional heat sink or spreader **2755.**

**FIG. 27B** illustrates top and side views of one embodiment for a DRAM die. A DRAM die **2760** includes a package (stack layer) **2766** with signal/power/GND balls **2762** and one or more extra power/GND balls **2764.** The extra power/GND balls **2764** increase thermal conductivity.

**FIG.27C** illustrates top and side views of one embodiment of a decoupling layer. A decoupling layer **2775** includes one ore more decoupling capacitors **2770,** signal/power/GND balls **2785,** and one or more extra power/GND balls **2780.** The extra power/GND balls **2780** increases thermal conductivity.

The extra power and ground balls, shown in **FIGS. 27B** and **27C****,** form thermal conductive paths between the memory integrated circuits and the PCB containing the stacks, and between the memory integrated circuits and optional heat sinks or heat spreaders. The decoupling capacitors in the power supply decoupling layer connect to the relevant power and ground pins in order to provide quiet voltage and ground rails to the memory devices in the stack.; The stacking technique described above is one method of providing quiet power and ground rails to the memory integrated circuits of the stack and also to conduct heat away from the memory integrated circuits.

In another embodiment, the noise on the power and ground rails may be reduced by preventing the DRAM integrated circuits in the stack from performing an operation simultaneously. As' mentioned previously, a large amount of current will be drawn from the power rails if all the DRAM integrated circuits in a stack perform a refresh operation simultaneously. The buffer integrated circuit may be designed to stagger or spread out the refresh commands to the DRAM integrated circuits in the stack such that the peak current drawn from the power rails is reduced. For example, consider a stack with four 1Gb DDR2 SDRAM integrated circuits that are emulated by the buffer integrated circuit to appear as, a single 4Gb DDR2 SDRAM integrated circuit to the host system. The JEDEC specification provides for a refresh cycle time (i.e. t_{RFc}) of 400ns for a 4Gb DRAM integrated circuit while a 1Gb DRAM integrated circuit has a t_{RFc} specification of 110ns. So, when the host system issues a refresh command to the emulated 4Gb DRAM integrated circuit, it expects the refresh to be done in 400ns. However, since the stack contains four 1Gb DRAM integrated circuits, the buffer integrated circuit may issue separate refresh commands to each of the 1Gb DRAM integrated circuit in the stack at staggered intervals. As an example, upon receipt of the refresh command from the host system, the buffer integrated circuit may issue a refresh command to two of the four 1Gb DRAM integrated circuits, and 200ns later, issue a separate refresh command to the remaining two 1Gb DRAM integrated circuits. Since the 1Gb DRAM integrated circuits require 110ns to perform the refresh operation, all four 1Gb DRAM integrated circuits in the stack will have performed the refresh operation before the 400ns refresh cycle time (of the 4Gb DRAM integrated circuit) expires. This staggered refresh operation limits the maximum current that may be drawn from the power rails. It should be noted that other implementations that provide the same benefits are also possible, and are covered by the scope of the claims.

In one embodiment, a device for measuring the ambient, case, or junction temperature of the memory integrated circuits (*e.g.* a thermal diode) can be embedded into the stack. Optionally, the buffer integrated circuit associated with a given stack may monitor the temperature of the memory integrated circuits. When the temperature exceeds a limit, the buffer integrated circuit may take suitable action to prevent the over-heating of and possible damage to the memory integrated circuits. The measured temperature may optionally be made available to the host system.

Other features may be added to the buffer integrated circuit so as to provide optional features. For example, the buffer integrated circuit may be designed to check for memory errors or faults either on power up or when the host system instructs it do so. During the memory check, the buffer integrated circuit may write one or more patterns to the memory integrated circuits in the stack, read the contents back, and compare the data read back with the written data to check for stuck-at faults or other memory faults.

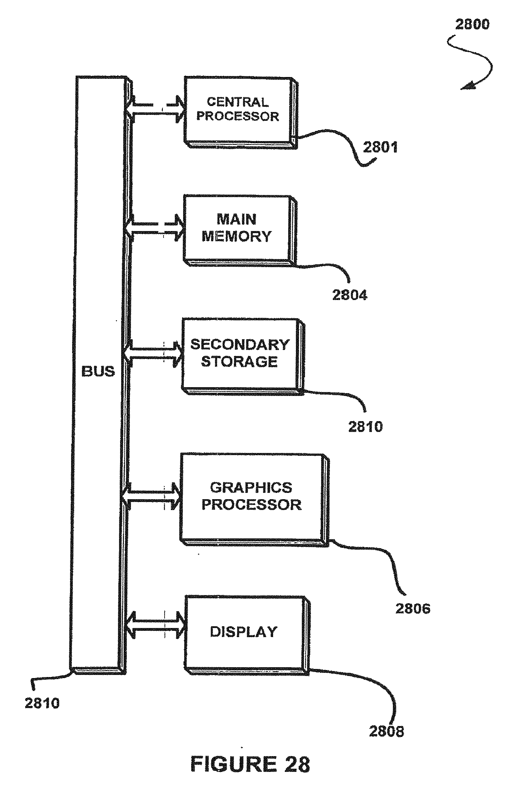

Figure **28** illustrates a representative hardware environment **2800,** in accordance with one embodiment. As an option, the hardware environment **2800** may be implemented in the context of Figures **1-27****.** Of course, the hardware environment **2800** may be implemented in any desired environment. Further, the aforementioned definitions may equally apply to the description below.

In one exemplary embodiment, the hardware environment **2800** may include a computer system. As shown, the hardware environment **2800** includes at least one central processor **2801** which is connected to a communication bus **2802.** The hardware environment **2800** also includes main memory **2804.** The main memory **2804** may include, for example random access memory (RAM) and/or any other desired type of memory. Further, in various embodiments, the main memory **2804** may include memory circuits, interface circuits, etc.

The hardware environment **2800** also includes a graphics processor **2806** and a display **1508.** The hardware environment **2800** may also include a secondary storage **2810.** The secondary storage **2810** includes, for example, a hard disk drive and/or a removable storage drive, representing a floppy disk drive, a magnetic tape drive, a compact disk drive, etc. The removable storage drive reads from and/or writes to a removable storage unit in a well known manner.

Computer programs, or computer control logic algorithms, may be stored in the main memory **2804** and/or the secondary storage **2810.** Such computer programs, when executed, enable the computer system **2800** to perform various functions. Memory **2804,** storage **2810** and/or any other storage are possible examples of computer-readable media.

While various embodiments have been described above, it should be understood that they have been presented by way of example only, and not limitation. Thus, the breadth and scope of a preferred embodiment should not be limited by any of the above-described exemplary embodiments, but should be defined only in accordance with the following claims and their equivalents.

Although the present invention is defined in the attached claims, it is to be understood that the invention can alternatively also be defined in accordance with the following embodiments:

### Embodiments:

1. A sub-system, comprising:
   an interface circuit capable of communication with a plurality of memory circuits and a system, the interface circuit operable to interface the memory circuits and the system for reducing command scheduling constraints of the memory circuits.
2. The sub-system as set forth in embodiment 1, wherein the command scheduling constraints include inter-device command scheduling constraints.
3. The sub-system as set forth in embodiment 1, wherein the inter-device command scheduling constraints are selected from the group consisting of a rank-to-rank data bus turnaround time, and an on-die-termination (ODT) control switching time.
4. The sub-system as set forth in embodiment 1, wherein the command scheduling constraints include intra-device command scheduling constraints.
5. The sub-system as set forth in embodiment 4, wherein the intra-device command scheduling constraints are selected from the group consisting of a column-to-column delay time (tCCD), a row-to-row activation delay time (tRRD), a four-bank activation window time (tFAW), and a write-to-read turn-around time (tWTR).
6. The sub-system as set forth in embodiment 1, wherein the command scheduling constraints of the memory circuits are reduced by controlling a manner in which commands are issued to the memory circuits.
7. The sub-system as set forth in embodiment 1, wherein the memory circuits include physical memory circuits, and the interface circuit is operable to simulate at least one virtual memory circuit.
8. The sub-system as set forth in embodiment 7, wherein the at least one virtual memory circuit has less command scheduling constraints than the physical memory circuits.
9. The sub-system as set forth in embodiment 7, wherein the command scheduling constraints of the physical memory circuits are reduced by issuing commands directed to a single virtual memory circuit, to a plurality of different physical memory circuits.
10. The sub-system as set forth in embodiment 6, wherein the commands are selected from the group consisting of row-access commands and column-access commands.
11. The sub-system as set forth in embodiment 6, wherein the commands are issued to different memory circuits utilizing separate busses.
12. The sub-system as set forth in embodiment, wherein the reduction of the command scheduling constraints of the 'memory circuits results in an increase of in a command issue rate.
13. The sub-system as set forth in embodiment 1, wherein the interface circuit includes a circuit that is positioned on a' dual in-line memory module (DIMM).
14. The sub-system as set forth in embodiment 1, wherein the interface circuit is selected from the group consisting of a buffer, a register, a memory controller, and an advanced memory buffer (AMB).
15. The sub-system as set forth in embodiment 1, wherein the interface circuit and the memory circuits take the form of a stack.
16. The sub-system as set forth in embodiment 1, wherein the memory circuits include a plurality of dynamic random I access memory (DRAM) circuits.
17. A method, comprising:
   interfacing a plurality of memory circuits and a system; and
   reducing command scheduling constraints of the memory circuits.
18. A system, comprising:
   a plurality of memory circuits; and
   an interface circuit in communication with the memory circuits, the interface circuit operable to interface the memory circuits for reducing command scheduling constraints of the memory circuits.
19. The system as set forth in embodiment 18, wherein the memory circuits and the interface circuit are positioned on a dual in-line memory module (DIMM).
20. The system as set forth in embodiment 18, wherein the memory circuits and the interface circuit are positioned on a memory module that remains in communication with a processor via a bus.
21. A sub-system, comprising:
   an interface circuit capable of communication with a plurality of memory circuits and a system, the interface circuit operable to translate an address associated with a command communicated between the system and the memory circuits.
22. The sub-system as set forth in embodiment 21, wherein the translation includes shifting the address.
23. The sub-system as set forth in embodiment 21, wherein the memory circuits include physical memory circuits, and the interface circuit is operable to simulate at least one virtual memory circuit.
24. The sub-system as set forth in embodiment 23, wherein the at least one virtual memory circuit has a different number of row addresses than the physical memory circuits.
25. The sub-system as set forth in embodiment 23, wherein the at least one virtual memory circuit has a greater number of row addresses than the physical memory circuits.
26. The sub-system as set forth in embodiment 24, wherein the translation is performed as a function of the difference in the number of row addresses.
27. The sub-system as set forth in embodiment 24, wherein the translation translates the address to reflect the number of row addresses of the at least one virtual memory circuit.
28. The sub-system as set forth in embodiment 21, wherein the translation results in sub-row activation.
29. The sub-system as set forth in embodiment 21, wherein the translation translates the address as a function of a column address and a row address.
30. The sub-system as set forth in embodiment 21, wherein the command includes a row- access command, and the translation ensures that a column-access command addresses an open bank.
31. The sub-system as set forth in embodiment 21, wherein the command includes a row-access command, and the translation is performed as a function of an expected arrival time of a column-access command.
32. The sub-system as set forth in embodiment 21, wherein the interface circuit is further operable to delay the command communicated between the system and the memory circuits.
33. The sub-system as set forth in embodiment 21, wherein the command includes at least one of a row-access command and a column-access command.
34. The sub-system as set forth in embodiment 21, wherein the translation is transparent to the system.
35. The sub-system as set forth in embodiment 21, wherein the interface circuit includes a 1 circuit that is positioned on a dual in-line memory module (DIMM).
36. The sub-system as set forth in embodiment 21, wherein the interface circuit is selected from the group consisting of a buffer, a register, a memory controller, and an advanced memory buffer (AMB).
37. A method, comprising:
   interfacing a plurality of memory circuits and a system; and
   translating an address associated with a command communicated between the system and the memory circuits.
38. A system, comprising:
   a plurality of memory circuits; and
   an interface circuit in; communication with the memory circuits, the interface circuit operable to translate an address associated with a command communicated between the system and the memory circuits.
39. The system as set forth in embodiment 38, wherein the memory circuits and the interface circuit are positioned on a dual in-line memory module (DIMM).
40. The system as set forth in embodiment 38, wherein the memory circuits and the interface circuit are positioned on a memory module that remains in communication with a processor via a bus.
41. A memory module comprising:
   at least one memory stack that comprises a plurality of DRAM integrated circuits; and
   buffer circuit, coupled to a host system, for interfacing said memory stack to said host system for transforming one or more physical parameters between said DRAM integrated circuits and said host system.
42. The memory module as set forth in embodiment 41, wherein:
   said memory module further comprises a dual rank DIMM for mounting said DRAM integrated circuits; and
   said buffer circuit further comprises a circuit to transform the electrical loading of said dual rank DIMM into a single rank DIMM.
43. The memory module as set forth in embodiment 41, wherein said buffer comprises a module to monitor the power supply rails, such as voltage rails or voltage planes, and detect a catastrophic event, such as a power supply failure.
44. The memory module as set forth in embodiment 41, wherein said buffer circuit comprises a module to monitor the state of the signals from a memory controller of said host system to detect a system crash.
45. The memory module as set forth in embodiment 41, wherein said buffer circuit further comprises a module to ignore signals from a memory controller of said host system, to generate legal combinations of signals to maintain data, stored in said DRAM integrated circuits, and to generate periodic refresh signals for said DRAM integrated circuits upon detection of a system crash.
46. The memory module as set forth in embodiment 41, wherein said buffer circuit further comprises a module to compensate for any skews or timing variations in signals transferred between said host system and said DRAM memory integrated circuits.
47. The memory module as set forth in embodiment 41, wherein said buffer circuit comprises:
   a plurality of I/O pins; and
   a circuit to control a slew rate, pull-up capability or strength, and pull-down capability or strength to at least one of said I/O pins.
48. A memory module comprising:
   at least one memory stack that comprises a plurality of DRAM integrated circuits; and
   buffer circuit, coupled to a host system, for interfacing said memory stack to said host system for configuring one or more of said DRAM integrated circuits in said memory stack.
49. The memory module as set forth in embodiment 48, wherein:
   said DRAM memory integrated circuits comprise slow DRAM memory integrated circuits; and
   said buffer circuit for emulating high-speed DRAM operation to said host system.
50. The memory module as set forth in embodiment 48, wherein said buffer circuit comprises:
   a plurality of integrated circuit select inputs; and
   circuit for configuring a plurality of DRAM integrated circuits in said memory stack to match a number of valid integrated circuit select inputs received by said buffer circuit from said host system.
51. The memory module as set forth in embodiment 48, wherein:
   said memory stack comprises at least one non-volatile memory device; and
   said buffer circuit further for copying data from at least one of said DRAM memory integrated circuits to said non-volatile memory upon detection of a catastrophic event.
52. The memory module as set forth in embodiment 48, wherein:
   said buffer circuit further for exposing a greater number of banks than a number of banks in said memory stack.
53. The memory module as set forth in embodiment 48, wherein:
   said buffer circuit further for exposing a lesser number of banks than a number of banks in said memory stack.
54. A memory module comprising:
   at least one memory stack that comprises a plurality of DRAM integrated circuits; and
   buffer circuit, coupled to a host system, for interfacing said memory stack to said host system for providing at least one function to said host system.
55. The memory module as set forth in embodiment 54, wherein:
   said memory module further comprises a DIMM, including a plurality of slots, for mounting said DRAM integrated circuits; and
   said buffer circuit comprises a circuit to permit said host system to maintain open a maximum number of memory pages even though a number of DIMM slots are fewer than a maximum number of DIMM slots said host system is capable of supporting.
56. The memory module as set forth in embodiment 54, wherein said buffer circuit comprises a circuit for allocating at least one of said DRAM integrated circuits to a first operating system or thread in an active state and allocating at least one other of said DRAM integrated circuits to a second operating system or threads, which is not currently being executed, in a low power or power down mode.
57. The memory module as set forth in embodiment 54, wherein said buffer circuit for mapping addresses for said host system to access data in said DRAM integrated circuits.
58. The memory module as set forth in embodiment 57, wherein said addresses comprise linear addresses.
59. The memory module as set forth in embodiment 57, wherein said addresses comprise bank-slice addresses.
60. The memory module as set forth in embodiment 54, wherein the buffer integrated circuit, includes integrated circuits to enable the buffer integrated circuit to gang a plurality of DRAM devices operating at a first clock speed to emulate to the host system one or more DRAM integrated circuits operating at a second clock speed, the first clock speed slower than the second clock speed.
61. A computer system comprising:
   host system;
   at least one memory stack that comprises a plurality of DRAM integrated circuits; and
   buffer circuit, coupled to said host system, for interfacing said memory stack to said host system for transforming one or more physical parameters between said DRAM integrated circuits and said host system.
62. The computer system as set forth in embodiment, wherein:
   said memory module further comprises a dual rank DIMM for mounting said DRAM integrated circuits; and
   said buffer circuit further comprises a circuit to transform the electrical loading of said dual rank DIMM into a single rank DIMM.
63. A printed circuit motherboard comprising:
   at least one memory stack that comprises a plurality of DRAM integrated circuits; and
   buffer circuit, coupled to a host system, for interfacing said memory stack to said host system for transforming one or more physical parameters between said DRAM integrated circuits and said host system.
64. The printed circuit motherboard as set forth in embodiment 63, wherein:
   said printed circuit motherboard further comprises a dual rank DIMM for mounting said DRAM integrated circuits; and
   said buffer circuit further comprises a circuit to transform the electrical loading of I said dual rank DIMM into a single rank DIMM.
65. The printed circuit motherboard as set forth in embodiment 63, wherein said buffer comprises a module to monitor the power supply rails, such as voltage rails or voltage planes, and detect a catastrophic event, such as a power supply failure.
66. The printed circuit motherboard as set forth in embodiment 63, wherein said buffer circuit comprises a module to monitor the state of the signals from a memory controller of said host system to detect a system crash.
67. The printed circuit motherboard as set forth in embodiment 63, wherein said buffer circuit further comprises a module to ignore signals from a memory controller of said host system, to generate legal combinations of signals to maintain data, stored in said DRAM DRAM integrated circuits, and to generate periodic refresh signals for said DRAM integrated circuits upon detection of a system crash.
68. The printed circuit motherboard as set forth in embodiment 63, wherein said buffer circuit further comprises a module to compensate for any skews or timing variations in signals transferred between said host system and said DRAM memory integrated circuits.
69. The printed circuit motherboard as set forth in embodiment 63, wherein said buffer circuit comprises:
   a plurality of I/O pins; and
   a circuit to control a slew rate, pull-up capability or strength, and pull-down capability or strength to at least one of said I/O pins.
70. A memory module comprising:
   at least one memory stack that comprises a plurality of DRAM integrated circuits; and
   interface circuit, coupled to a host system, for interfacing said memory stack to said host system so to operate said memory stack as a single DRAM integrated circuit.
71. The memory module as set forth in embodiment 70, wherein said interface circuit comprises a buffer integrated circuit incorporated as part of said memory stack.
72. The memory module as set forth in embodiment 70, wherein said memory module comprises an un-buffered DIMM.
73. The memory module as set forth in embodiment 70, wherein said memory module comprises a registered DIMM.
74. The memory module as set forth in embodiment 70, wherein said memory module comprises a SO-DIMM.
75. The memory module as set forth in embodiment 70, wherein said memory module comprises a FB-DIMM.
76. The memory module as set forth in embodiment 70, further comprising:
   a raw card;
   said memory module electrically coupled to said raw card; and
   one or more electrical circuits electrically coupled to said raw card, said one or more electrical circuits buried at least partially beneath a plane defining a first primary surface of said raw card.
77. A memory module comprising:
   at least one memory stack that comprises a plurality of DRAM integrated circuits; and
   buffer integrated circuit, coupled to a host system, for interfacing said memory stack to said host system so to operate said memory stack as at least two DRAM integrated circuits.
78. The memory module as set forth in embodiment 77, wherein said buffer integrated circuit further for interfacing said memory stack to said host system so to operate said memory stack as at least two ranks of DRAM integrated circuits.
79. The memory module as set forth in embodiment 77, wherein said memory stack comprises a buffer and a plurality of DRAM integrated circuits.
80. The memory module as set forth in embodiment 77, further comprising:
   a first printed circuit board for mounting said ranks of DRAM integrated circuits; and
   a second printed circuit board comprising at least one additional memory stack, coupled to said memory by means of a connector or interposer.
81. The memory module as set forth in embodiment 80, wherein:
   said second printed circuit board comprises a DIMM with said interposer located on a front side of said DIMM.
82. The memory module as set forth in embodiment 80, wherein:
   said second printed Circuit board comprises a DIMM with said interposer located on a back side of said DIMM.
83. The memory module as set forth in embodiment 77, wherein said memory stack further comprises at least one non-volatile memory integrated circuit.
84. The memory module as set forth in embodiment 77, wherein said buffer integrated circuit further for operating two DDR2 SDRAM integrated circuits in parallel so as appear as a single DDR3 SDRAM integrated circuit to the host system.
85. The memory module as set forth in embodiment 77, wherein one or more layers of said memory stack further comprises at least one decoupling capacitor.
86. A computer system comprising:
   a memory controller; and
   at least one memory module comprising:
      at least one memory stack that comprises a plurality of DRAM integrated circuits; and
      interface circuit, coupled to said memory controller, for interfacing said memory stack to said memory controller so to operate said memory stack as a single DRAM integrated circuit.
87. The computer system as set forth in embodiment 86, wherein said DRAM integrated circuits of said memory module further comprising a ganged configuration for RAID memory.
88. The computer system as set forth in embodiment 86, wherein said DRAM integrated circuits of said memory module further comprising a configuration for distributed power dissipation.
89. The computer system as set forth in embodiment 86, wherein one or more of said DRAM integrated circuits in said stack of said memory module comprises a device for measuring i ambient temperature of said memory module.
90. The computer system as set forth in embodiment 86, wherein one or more of said DRAM integrated circuits in said stack of said memory module comprises a capacitor.
91. The computer system as set forth in embodiment 86, wherein one or more of said DRAM integrated circuits in said stack of said memory module comprises a plurality of power and ground pins.
92. A computer system comprising:
   a memory controller; and
   at least one memory module comprising:
      at least one memory stack that comprises a plurality of DRAM integrated circuits; and
      buffer integrated circuit, coupled to a host said memory controller, for interfacing said memory stack to said memory controller so to operate said memory stack as at least two DRAM integrated circuits.
93. A memory module comprising:
   at least one memory stack that comprises a plurality of DRAM integrated circuits; and
   interface circuit, coupled to a host system, for mapping virtual addresses from said host system to physical addresses of said DRAM integrated circuits in a linear manner.
94. The memory module as set forth in embodiment 93, wherein:
   said physical addresses identify at least one physical bank; and
   said interface circuit for mapping a physical bank to a different one of said DRAM integrated circuits.
95. A memory module comprising:
   at least one memory stack that comprises a plurality of DRAM integrated circuits; and
   interface circuit, coupled to a host system, for mapping one or more banks of virtual addresses from said host system to a single one of said DRAM integrated circuits.
96. A printed circuit motherboard comprising:
   at least one memory stack that comprises a plurality of DRAM integrated circuits; and
   interface circuit, coupled to a host system, for interfacing said memory stack to said host system so to operate said memory stack as a single DRAM integrated circuit.
97. The printed circuit motherboard as set forth in embodiment 96, wherein said interface circuit comprises a buffer integrated circuit incorporated as part of said memory stack.
98. The printed circuit motherboard as set forth in embodiment 96, wherein said printed circuit motherboard comprises an un-buffered DIMM.
99. The printed circuit Motherboard as set forth in embodiment 96, wherein said printed circuit motherboard comprises a registered DIMM.
100. The printed circuit motherboard as set forth in embodiment 96, wherein said printed circuit motherboard comprises a SO-DIMM.
101. The printed circuit motherboard as set forth in embodiment 96, wherein said printed circuit motherboard comprises a FB-DIMM.

A number of implementations have been described. Nevertheless, it will be understood that various modifications may be made without departing from the spirit and scope of the following claims. Accordingly, other implementations are within the scope of the following claims.

## Claims

1. A memory module comprising:
at least one memory stack that comprises a plurality of DRAM integrated circuits; and
buffer circuit, coupled to a host system, for interfacing said memory stack to said host system for transforming one or more physical parameters between said DRAM integrated circuits and said host system,
wherein:
said memory module further comprises a dual rank DIMM for mounting said DRAM integrated circuits; and
said buffer circuit further comprises a circuit to transform the electrical loading of said dual rank DIMM into a single rank DIMM.

2. The memory module as set forth in claim 1, wherein said buffer circuit further comprises a module to compensate for any skews or timing variations in signals transferred between said host system and said DRAM memory integrated circuits.

3. The memory module as set forth in claim 1 or 2, wherein said buffer circuit comprises:
a plurality of I/O pins; and a circuit to control a slew rate, pull-up capability or strength, and pull-down capability or strength to at least one of said I/O pins.

4. The memory module as set forth in any of claim 1 to 3, wherein the buffer circuit includes per-pin timing calibration and compensation circuits.

5. The memory module as set forth in claim 4, wherein the per-pin timing calibration and compensation circuits allow the buffer integrated circuit to compensate for timing variations in the I/O ins of the DRAM devices.

6. The memory module as set forth in claim 4 or 5, wherein the per-pin timing calibration and compensation circuits enables the buffer circuit to gang the plurality of slower DRAM devices to emulate a higher speed DRAM integrated circuit to the host system.

7. The memory module as set forth in claim 1, wherein said buffer comprises a module to monitor the power supply rails, such as voltage rails or voltage planes, and detect a catastrophic event, such as a power supply failure.

8. The memory module, as set forth in claim 1, wherein said buffer circuit comprises a module to monitor the state of the signals from a memory controller of said host system to detect a system crash.

9. The memory module as set forth in claim 1, wherein said buffer circuit further comprises a module to ignore signals from a memory controller of said host system, to generate legal combinations of signals to maintain data, stored in said DRAM integrated circuits, and to generate periodic refresh signals for said DRAM integrated circuits upon detection of a system crash.
